# DEMANDE DE BREVET EUROPEEN

(11) **EP 4 435 867 A1**
(43) Date de publication de la demande: **25.09.2024**
(21) Numéro de dépôt: 24165157.9
(22) Date de dépôt: 21.03.2024
(51) Int. Cl.: H01L 29/06, H01L 29/423, H01L 29/66, G06N 10/40, B82Y 10/00

(54) **CIRCUIT ÉLECTRONIQUE QUANTIQUE ET PROCÉDÉ DE FABRICATION ASSOCIÉ**

(30) Priorité: 22.03.2023 FR 2302705
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR); BERTRAND, Benoit, 38054 GRENOBLE CEDEX 09 (FR); BEDECARRATS, Thomas, 38054 GRENOBLE CEDEX 09 (FR)
(74) Mandataire: Cabinet Camus Lebkiri

(57) **Abrégé**

Un aspect de l'invention concerne un circuit (1) électronique comprenant :
- une couche semiconductrice (2), dite « couche qubits » ;

- des piliers semiconducteurs (3), distants les uns des autres, s'étendant perpendiculairement à la face avant (2a) de la couche qubits (2) depuis et intégrale avec la couche qubits (2),
- une couche de séparation (42) s'étendant au contact de la couche qubits (2) ;
- des premières électrodes conductrices (61), dites « lignes de couplage », s'étendant parallèlement à la couche qubits (2) ;
- des deuxièmes électrodes conductrices (62), dites « colonnes de couplage », s'étendant parallèlement à la couche qubits (2) ;
- des troisièmes électrodes conductrices (71), dites « lignes de contrôle », s'étendant sur l'espaceur (42) ; et
- des vias conducteurs (72), dits « vias de contrôle », s'étendant perpendiculairement à la face couche qubits (2) depuis l'espaceur (42) et présentant une extrémité disposée à proximité de la couche qubits (2),

- les troisièmes électrodes conductrices (62) et les vias conducteurs (72) étant configurés pour moduler le potentiel électrostatique au niveau de la couche qubits et former des boîtes quantiques dans la couche qubits.

## Description

### DOMAINE TECHNIQUE DE L'INVENTION

Le domaine technique de l'invention est celui de l'électronique quantique et plus particulièrement de la fabrication d'un circuit électronique quantique.

### ARRIÈRE-PLAN TECHNOLOGIQUE DE L'INVENTION

La manipulation d'états quantiques, également appelés "qubits" pour "quantum bits" en anglais, offre de nouvelles possibilités dans la manipulation d'information. Les circuits électroniques quantiques à même de permettre la manipulation de qubits, comprennent des îlots, également appelés boîtes quantiques. Les boîtes quantiques sont capables de stocker des qubits le temps de leur manipulation et de leur mesure.

L'intégration de boîtes quantiques sous forme de circuits électroniques quantiques doit satisfaire plusieurs exigences. D'une part offrir une haute densité de boîtes quantiques afin d'offrir une capacité de calcul conséquente. D'autre part, les procédés de fabrication desdits circuits électroniques quantiques doivent permettre d'atteindre une cadence de production industrielle tout en assurant une faible variabilité des circuits. En effet, le stockage et la manipulation des qubits au sein de boîtes quantiques sont fortement tributaires des couplages entre les différents composants formant les circuits électroniques quantiques.

Les circuits électroniques quantiques doivent offrir la possibilité de coupler plusieurs qubits entre eux pour permettre d'effectuer un calcul à partir d'un ensemble de qubits. Dans certains cas, l'opération de couplage s'effectue en contrôlant un couplage tunnel entre des boites quantiques contenant les qubits. En revanche, le contrôle des couplages tunnels impose une architecture des boites quantiques interconnectées sous forme de matrices denses. De plus, les boîtes quantiques doivent également pouvoir être couplées à des réservoirs de porteurs de charge et des détecteurs de charge. Afin de permettre la densification des boîtes quantiques, il est proposé d'intégrer et connecter les réservoirs de porteurs de charges et les détecteurs de charges dans des plans différents du plan comprenant les boîtes quantiques. On parle dans ce cas de circuits à architecture non-planaire, dite également "3D" pour "à 3 dimensions".

Deux types de circuits à architecture 3D émergent aujourd'hui. Les circuits dits à contrôle individuel des qubits d'une part, également appelé "fully controlled" en anglais, et les circuits dits à contrôle parallèle des qubits d'autre part, également appelé "crossbar network". Si les circuits à contrôle individuel facilitent la manipulation des qubits, ils présentent en revanche une architecture électrique complexe, avec une forte densité de vias et d'interconnexions. Les circuits à contrôle parallèle offrent quant à eux une architecture plus simple, notamment grâce à la réduction de la densité de vias et d'interconnexions.

La demande de brevet FR 3 066 297 propose un circuit électronique quantique à contrôle parallèle comprenant une couche semiconductrice et un réseau d'électrodes disposé de chaque côté de cette couche semiconductrice. Le premier réseau d'électrodes permet de contrôler le couplage des boîtes quantiques avec les réservoirs de charge et les détecteurs de charge. Le second réseau d'électrodes permet de contrôler le couplage entre les boîtes quantiques. Le bon fonctionnement du circuit divulgué repose toutefois sur le bon alignement des deux réseaux de part et d'autres de la couche semiconductrice.

La fabrication d'un tel circuit nécessite la formation du premier réseau d'électrodes et le retournement de la couche semiconductrice pour former le deuxième réseau ou bien le report sur la première couche semiconductrice d'une autre couche semiconductrice sur laquelle ce 2^{ème} réseau a été fabriqué. Ces étapes de formations comprennent notamment le collage et le retournement du substrat et une libération de la face arrière des boîtes quantiques pour former le deuxième réseau d'électrodes. Les étapes de collage/retournement peuvent être difficiles à réaliser et peuvent occasionner des défauts au niveau de l'interface de collage, tels qu'un désordre électrostatique. De plus, les variations d'alignements des piliers par rapport aux boîtes quantiques peuvent modifier le couplage entre lesdits piliers et les boîtes quantiques.

Il existe donc un besoin de fournir un circuit électronique qui ne souffre pas de défaut au niveau des interfaces, ni de problème d'alignement.

### RÉSUME DE L'INVENTION

L'invention offre une solution au problème évoqué, en permettant de réaliser un circuit électronique quantique avec les deux réseaux d'électrodes sur un même côté de la couche semiconductrice. La fabrication de ce dispositif ne requiert plus le retournement du substrat ni un collage pour former les deux réseaux, elle ne présente plus non plus de problème d'alignement.

Pour cela, l'invention concerne un circuit électronique comprenant :
- une couche semiconductrice, dite « couche qubits », présentant une première face ;
- des piliers semiconducteurs, distants les uns des autres, s'étendant perpendiculairement à la face avant de la couche qubits depuis la couche qubits, chaque pilier semiconducteur comprenant une première extrémité, dite « base », en contact avec la face avant de la couche qubits ;
- des couches diélectriques dites « diélectriques de flanc », chaque diélectrique de flanc entourant le flanc d'un des piliers semiconducteurs ;
- une couche diélectrique dite « espaceur » s'étendant au contact de la face avant de la couche qubits et entourant la base de chaque pilier semiconducteur ;
- des premières électrodes conductrices, dites « lignes de couplage », parallèles les unes aux autres et s'étendant parallèlement à la face avant de la couche qubits, chaque ligne de couplage étant en contact avec le diélectrique de flanc d'au moins un des piliers semiconducteurs ;
- des deuxièmes électrodes conductrices dites « colonnes de couplage », parallèles les unes aux autres et perpendiculaires aux lignes de couplage, s'étendant parallèlement à la face avant de la couche qubits et distantes des lignes de couplage, chaque colonne de couplage étant en contact avec le diélectrique de flanc d'au moins un des piliers semiconducteurs ;
le circuit étant caractérisé en ce qu'il comprend également :
- des troisièmes électrodes conductrices, dites « lignes de contrôle », parallèles les unes aux autres et parallèles aux lignes de couplages et s'étendant sur l'espaceur, préférentiellement au contact de l'espaceur, chaque ligne de contrôle étant distante des lignes de couplage, des colonnes de couplage et des diélectriques de flanc des piliers semiconducteurs ; et
- des vias conducteurs, dits « vias de contrôle », distants des colonnes de couplage, des lignes de contrôle et des diélectriques de flanc des piliers semiconducteurs, chacun des vias de contrôle s'étendant perpendiculairement à la face avant de la couche qubits, chaque via présentant une première extrémité disposée à proximité de la face avant de la couche qubit, sans contact électrique avec la couche qubits.

Les termes « parallèlement » et « perpendiculairement » peuvent être lus en prenant en compte une incertitude imposée par les techniques de fabrication en vigueur. Par exemple, par « parallèlement à la face avant de la couche qubits », on entend parallèle à ladite face à +/- 20° près. De même, par « perpendiculairement à la face avant de la couche qubits », on entend perpendiculaire à +/- 20° près. Par « parallèlement aux lignes de couplage », on entend parallèle à +/- 20° près. Par « perpendiculaire aux lignes de couplage », on entend perpendiculaire à +/- 20° près.

Lorsqu'il est indiqué que des lignes et des colonnes s'étendent perpendiculairement les unes aux autres, elles s'étendent perpendiculairement par projection. Elles ne s'entrecoupent pas et ne sont pas en contact direct.

Par « disposé à proximité d'une face », on entend disposé, sans contact direct ni contact électrique, à moins de 20 nm de cette face et préférentiellement à moins de 10 nm de cette face et de manière très avantageuse, à moins de 5 nm de cette face.

La couche qubits est une couche destinée à recevoir des qubits. Les lignes et vias de contrôle permettent de former une première matrice, dite « matrice de contrôle », permettant de moduler le potentiel électrostatique au niveau de la couche qubits et former ainsi des boîtes quantiques permettant de recevoir des qubits. Les lignes et colonnes de couplage permettent de former une deuxième matrice, dite « matrice de couplage », enchevêtrée dans la matrice de contrôle, permettant de moduler le potentiel électrostatique au niveau des piliers semiconducteurs.

Les matrices de contrôle et de couplage étant disposées du même côté de la couche qubits, en face avant, il n'est pas nécessaire de retourner la couche qubits afin de réaliser leur formation, ni réaliser de collage sur la couche qubit. Ceci permet également d'éviter les problèmes d'alignement entre les matrices.

Avantageusement, la première extrémité de chaque via est disposée à proximité de la face avant de la couche qubit pour moduler le potentiel électrostatique dans la couche qubits.

Avantageusement, la première extrémité de chaque via est disposée à moins de 15 nm de la face avant de la couche qubits et de manière préférée à moins de 10 nm de la face avant de la couche qubits.

Avantageusement, l'épaisseur de l'espaceur est inférieure à 15 nm et de manière préférée à moins de 10 nm. Autrement dit, la distance séparant chaque ligne de contrôle de la couche qubits est inférieure à 15 nm voire inférieure à 10 nm.

Avantageusement, l'épaisseur de la couche qubits est comprise entre 5 nm et 35 nm.

Avantageusement, chaque ligne de contrôle est disposée entre deux lignes de couplage consécutives, préférentiellement à équidistance de ces deux lignes de couplage consécutives, et chaque via de contrôle est disposé entre deux colonnes de couplage consécutives, préférentiellement à équidistance de ces deux colonnes de couplages consécutives.

Avantageusement, chacun des vias de contrôle traverse, sans contact électrique, une des lignes couplages.

Avantageusement, chaque ligne de couplage s'étend sur l'espaceur.

Avantageusement, les lignes de couplage et les lignes de contrôle s'étendent dans un premier plan, parallèle à la première face de la couche qubit, dans lequel les colonnes de couplage s'étendent dans un deuxième plan également parallèle à la première face de la couche qubit, le premier plan étant disposé entre la première face de la couche qubit et le deuxième plan.

Avantageusement, chaque via présente une deuxième extrémité, opposée à la première extrémité, les deuxièmes extrémités d'une pluralité de vias étant électriquement connectées entre elles.

Avantageusement, les piliers sont disposés en quinconce.

Avantageusement, la première couche semiconductrice est en silicium et de préférence enrichi par un isotope, par exemple le silicium 28.

Avantageusement, la couche qubits et chaque pilier semiconducteur sont formés dans une même couche semiconductrice monocristalline.

Avantageusement, l'espaceur et les diélectriques de flanc sont une seule et même couche diélectrique s'étendant de manière continue sur la face avant de la couche qubits et les flancs des piliers semiconducteurs. Préférentiellement, ladite même couche diélectrique s'étendant de manière continue est un oxyde thermique.

Avantageusement, chaque pilier semiconducteur comprend une deuxième extrémité, dite « tête », opposée à la base, la tête du pilier semiconducteur comprend une surface de contact n'étant pas entourée par chaque le diélectrique de flanc. Par surface de contact, on entend que cette surface permet le contact direct avec le matériau semiconducteur du pilier semiconducteur. Autrement dit, chaque diélectrique de flanc entoure le flanc d'un des piliers semiconducteurs tout en laissant libre la surface de contact du flanc dudit pilier semiconducteur, au niveau de sa tête.

Avantageusement, le circuit comprend également des quatrièmes électrodes dites « lignes de lecture », chaque ligne de lecture étant en contact avec la surface de contact de la tête d'au moins un des piliers semiconducteurs.

Avantageusement, le circuit comprend également des structures de grilles dites « grilles de chargement », chaque grille de chargement étant en contact avec la tête d'au moins un des piliers semiconducteurs.

Un autre aspect de l'invention concerne un procédé de fabrication d'un circuit électronique, le procédé étant mis en oeuvre à partir d'un substrat comportant sur l'une de ses surfaces une première couche semiconductrice monocristalline et comprenant les étapes suivantes :
- former des piliers semiconducteurs distants les uns des autres, chaque pilier semiconducteur présentant une première extrémité, dite « base » ; et une couche semiconductrice dite « couche qubits », à la base de chaque pilier semiconducteur, la couche qubits présentant une première face dite « face avant » ;
- oxyder le flanc de chaque pilier semiconducteur et la face avant de la couche qubits de manière à former une première couche diélectrique comprenant des premières portions, dites « diélectriques de flanc », chaque diélectrique de flanc entourant le flanc d'un des piliers semiconducteurs, et une deuxième portion dite « espaceur », s'étendant au contact de la face avant de la couche qubits et entourant la base de chaque pilier semiconducteur ;
- former des premières électrodes conductrices dites « lignes de couplage », parallèles les unes aux autres et s'étendant parallèlement à la face avant de la couche qubits, chaque lignes de couplage étant en contact avec le diélectrique de flanc d'au moins un des piliers semiconducteurs ;
- former des troisièmes électrodes conductrices, dites « lignes de contrôle », parallèles les unes aux autres et parallèles aux lignes de couplages et s'étendant sur l'espaceur, chaque ligne de contrôle étant distante des lignes de couplage et des diélectriques de flanc des piliers semiconducteurs ;
- former des deuxièmes électrodes conductrices dites « colonnes de couplage », parallèles les unes aux autres et perpendiculaires aux lignes de couplage, s'étendant parallèlement à la face avant de la couche qubits et distantes des lignes de couplage et des lignes de contrôle, chaque colonne de couplage étant en contact avec le diélectrique de flanc d'au moins un des piliers semiconducteurs ;
- former des vias conducteurs, dits « vias de contrôle », distants des colonnes de couplage, des lignes de contrôle et des diélectriques de flanc des piliers semiconducteurs, chacun des vias de contrôle s'étendant perpendiculairement à la face avant de la couche qubits depuis l'espaceur et traversant, sans contact électrique, une des lignes couplages.

Le procédé permet ainsi de fabriquer un circuit électronique comprenant une couche qubits dans laquelle peut être formé des boîtes quantiques destinées à recevoir les qubits. Le procédé permet de former des piliers semiconducteurs présentant une continuité cristalline avec la couche qubits. Ainsi, la variabilité des circuits produits est réduite.

Avantageusement, les lignes de couplage et les lignes de contrôle sont formées simultanément.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention.
Les [Fig. 1], [Fig. 2] et [Fig. 3] présentent selon différentes vues, un circuit électronique selon l'invention.
La [Fig. 4] présente schématiquement le système équivalent du circuit des [Fig. 1] à [Fig. 3].
Les [Fig. 5], [Fig. 6], [Fig. 7], [Fig. 8], [Fig. 9], [Fig. 10], [Fig. 11], [Fig. 12], [Fig. 13], [Fig. 14], [Fig. 15], [Fig. 16], [Fig. 17], [Fig. 18], [Fig. 19], [Fig. 20], [Fig. 21], [Fig. 22], [Fig. 23], [Fig. 24], [Fig. 25], [Fig. 26], [Fig. 27], [Fig. 28] présentent des étapes d'un procédé permettant de fabriquer le circuit des [Fig. 1] à [Fig. 3].
La [Fig. 29] présente schématiquement un logigramme des étapes des [Fig. 5] à [Fig. 28].

Sauf précision contraire, un même élément apparaissant sur des figures différentes présente une référence unique.

Les figures sont présentées à titre indicatif et nullement limitatif de l'invention.

### DESCRIPTION DÉTAILLÉE

L'invention se propose de d'offrir un circuit électronique qui puisse être utilisé pour former un circuit électronique quantique. Ce circuit électronique est particulier en ce qu'il comprend deux réseaux d'électrodes, que l'on peut également appeler deux matrices d'électrodes, sur un même côté d'une couche semiconductrice destinée à accueillir des bits quantiques également appelé « qubits ». L'intérêt de disposer les circuits du même côté est de ne pas requérir de retournement du substrat pour le fabriquer.

Le circuit présente également une variabilité du comportement électronique réduite. La réduction de variabilité est notamment obtenue par la continuité cristalline la couche semiconductrice destinée à recevoir les qubits et des piliers semiconducteurs destinés à initialiser et mesurer lesdits qubits. En effet, le circuit ne présente pas d'interface entre ces deux éléments.

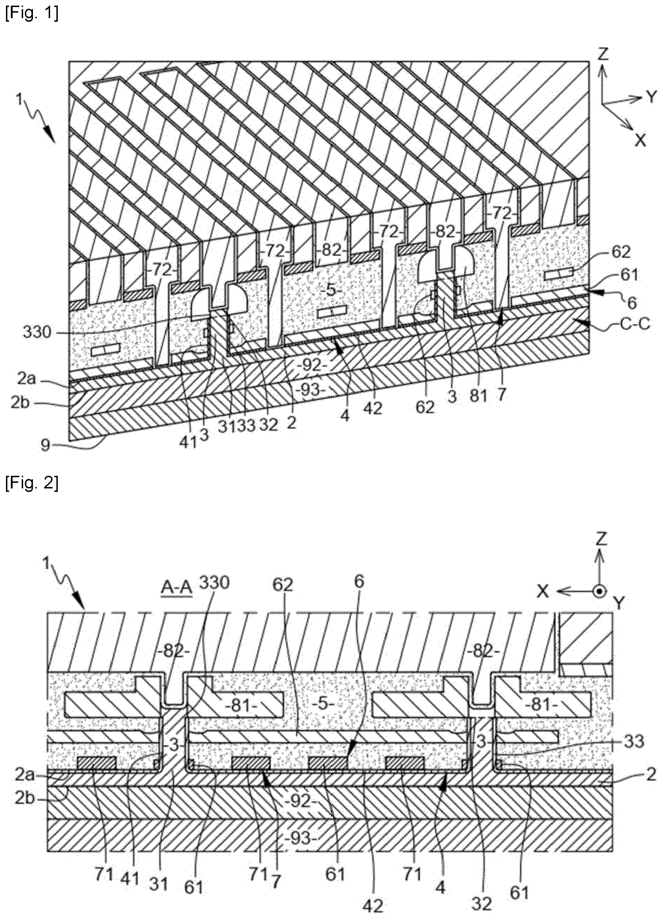

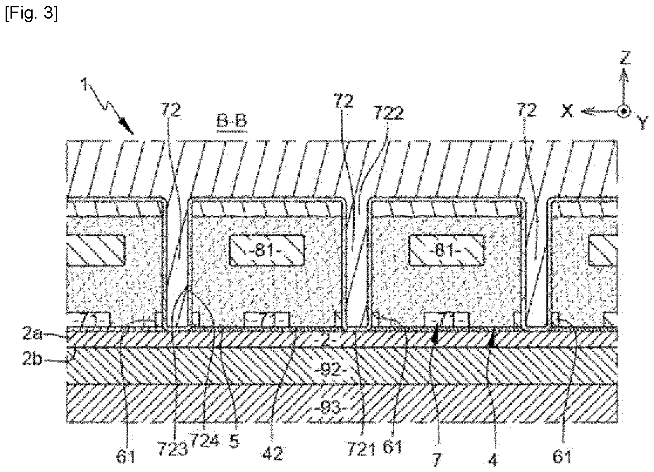

Les figures 1, 2 et 3 présentent un mode de réalisation du circuit électronique 1.

Le circuit 1 est formé sur un substrat 9 qui s'étend, dans les figures 1 à 3, dans un plan {X ; Y}. Le substrat 9 comprend une couche semiconductrice massive 93, par exemple en silicium sur laquelle repose une couche isolante 92 (que l'on appelle également BOX pour « Buried Oxyde layer » en anglais). La couche semiconductrice massive 93 offre un support mécanique au circuit 1. La couche isolante 92 permet d'isoler le circuit 1 de la couche massive 93.

Le circuit 1 comprend une couche semiconductrice 2, dite « couche qubits », reposant sur la couche isolante 92. La couche qubits 2 présente deux faces 2a, 2b opposées l'une à l'autre : une face avant 2a et une face arrière 2b. Par convention, la face arrière 2b est la face qui est en contact avec la couche isolante 92. La face avant 2a est préférentiellement planaire. Dans ce mode de réalisation, elle est parallèle à au plan {X ; Y}.

La couche qubits 2 est destinée à recevoir les qubits. Pour cela, elle montre préférentiellement des caractéristiques permettant de former des boîtes quantiques en son sein. Elle présente par une épaisseur, mesurée perpendiculairement au plan {X ; Y}, comprise entre 5 nm et 35 nm et de manière préférée entre 10 nm et 20 nm, par exemple égale à 15 nm. Elle peut également être cristalline, de manière à perturber le moins possible les qubits et également être compatible avec des procédés de fabrication standard dans le domaine. Elle peut également être formée à partir de silicium enrichi par un isotope tel que le silicium 28 et est préférentiellement composée de silicium enrichi par un isotope tel que le silicium 28. Ce dernier permet d'augmenter le temps de cohérence intrinsèque des qubits de la couche qubits 2. La concentration de silicium 28 dans la couche qubits 2 est par exemple supérieure à 99,9 %.

Le circuit 1 comprend également des piliers semiconducteurs 3. Les piliers 3 s'étendant selon une direction perpendiculaire à la couche qubits 2 et plus particulièrement à la face avant 2a de la couche qubits 2. Ils reposent sur la couche qubits 2, au contact direct de cette dernière. Dans le mode de réalisation des figures 1 à 3, les piliers 3 sont de forme cylindrique et s'étendent selon la direction Z, perpendiculaire au plan {X ; Y}. Les piliers 3 peuvent être formés dans le même matériau semiconducteur que la couche qubits 2, et de préférence de manière à créer une continuité cristalline dans les piliers 3 et la couche qubits 2. Le rôle des piliers 3 est de former des ponts entre des détecteurs de charges et des qubits qui se trouveraient sous lesdits piliers, dans la couche qubits 2, à la verticale desdits piliers.

Dans ce mode de réalisation, les piliers 3 présentent une section, considérée parallèlement à la face avant 2a, qui est circulaire. Ils présentent un diamètre préférentiellement compris entre 30 nm et 60 nm, par exemple égal à 50 nm. De manière alternative, les piliers 3 peuvent présenter une section elliptique ou rectangulaire (les limites de fabrication actuelles tendent plutôt à former rectangles arrondis plus que des rectangles parfaits, dans ce cas-là, on considère alors les rectangles parfaits conscrits sur les sections des piliers 3). La plus grande dimension de la section (c'est-à-dire le grand axe de l'ellipse ou le grand côté du rectangle conscrit) est préférentiellement comprise entre 30 nm et 60 nm.

Chaque pilier 3 présente deux extrémités 31, 32 opposées l'une à l'autre dite « base » et « tête ». Chaque pilier 3 repose sur la couche qubits 2 par sa base 31. Chaque pilier 3 présente également un flanc 33, c'est-à-dire une surface l'entourant et s'étendant de la base 31 jusqu'à la tête 32. Les piliers 3 représentés dans les figures 1 à 3 sont des cylindres parfaits, or les procédés de fabrication des piliers peuvent induire des variations de forme des piliers 2 sans que cela n'entache l'obtention des effets techniques associés aux piliers 3. Ils peuvent présenter une forme sensiblement tronconique ou tronconique inversée ou encore une combinaison de ces formes, telle qu'une forme de sablier ou de tonneau. Les flancs 33 de chaque pilier 3 sont donc perpendiculaire à la face avant 2a à plus ou moins 20° près.

Les piliers 3 sont distants les uns des autres. Dans le mode de réalisation des figures 1 à 3, les piliers 3 sont disposés en quinconce. La distance séparant les plus proches piliers voisins, mesurée parallèlement à la face avant 2a, est par exemple supérieure à 30 nm, voire 60 nm. Afin de conserver une densité d'intégration intéressant, il peut être recherché que cette distance soit inférieure ou égale à 100 nm.

Le circuit 1 présente également une couche diélectrique 4 s'étendant de manière continue sur la face avant 2a de la couche qubits 2, entourant la base de chaque pilier 3 et s'étendant sur les flancs 33 des piliers 3. On distingue une première portion 41 de la couche diélectrique 4, dite « espaceur », s'étendant sur la face avant 2a de la couche qubits et entourant la base 31 de chaque pilier 3. On distingue également des deuxièmes portions 42 de la couche diélectrique 4, dites « diélectriques de flanc » qui entourant le flanc 33 de chaque pilier 3.

La couche diélectrique 4 est par exemple obtenue par oxydation thermique de la face avant 2a de la couche qubits 2 et des flancs 33 de piliers 3. Étant donné que la couche qubits 2 et les piliers 3 sont préférentiellement formés dans le même matériau, le matériau diélectrique formant la couche diélectrique 4 est le même au niveau des différentes portions 41, 42. Il s'agit par exemple d'oxyde de silicium lorsque la couche qubits 2 et les piliers 3 sont en silicium. De manière alternative, la couche diélectrique 4 peut être formée par un dioxyde déposé plutôt que par oxydation des piliers 3 et de la couche qubits 2. La couche diélectrique 4 présente une épaisseur comprise entre 5 nm et 10 nm. L'épaisseur est mesurée perpendiculairement à la face avant 2a au niveau de l'espaceur 41 et perpendiculaire aux flancs des piliers au niveau des diélectriques de flanc 42.

Les diélectriques de flanc 42 ne recouvrent pas la totalité des piliers 3. Ils laissent libre une portion 330 annulaire du flanc 33, au niveau de la tête 32 dite « surface de contact ». Par exemple, dans le cas d'un pilier 3 présentant une forme cylindrique parfaite, ladite surface de contact 330 s'étend à partir de la section droite de ce cylindre, représentant la tête, et entoure le pilier 3.

Le circuit 1 comprend également deux ensembles 6, 7 d'électrodes 61, 62, 71, 72 dits « réseau de couplage » et « réseau de contrôle » ou encore « matrice de couplage » et « matrice de contrôle ».

Le rôle du réseau de contrôle 7 est de contrôler le potentiel électrostatique dans la couche qubits 2. Ceci permet par exemple de créer des confinements électrostatiques dans la couche qubits 2 de manière à former des boîtes quantiques à même de recevoir un qubits. Le réseau de contrôle 7 permet également de modifier la configuration électrostatique dans la couche qubits 2 pour coupler deux boîtes quantiques voisines. Ce mécanisme sous-tend les opérations quantiques réalisés avec les qubits.

Le réseau de contrôler 7 est configuré pour permettre de moduler le potentiel électrostatique dans la couche qubits 2 de sorte que des boîtes quantiques soient disposées au niveau de la base 31 de chaque pilier 3. En effet, la tête 32 de chaque pilier 3 peut être mise en relation avec un détecteur de charge ou un réservoir de charge (décrit plus bas) afin de, respectivement, mesurer l'état d'un qubit dans la boîte quantique ou initialiser cette boîte quantique. Le réseau de couplage 6 permet de contrôler le potentiel électrostatique au sein des piliers 3. Il permet ainsi de contrôler le couplage entre un qubits dans une boîte quantique (à la verticale d'un pilier 3) et un détecteur de charge ou un réservoir de charge.

La particularité de l'invention réside dans la disposition de ces deux réseaux 6, 7 qui sont disposés du même côté de la couche qubits 2, notamment en regard de la face avant 2a.

Les lignes et colonnes de couplage 61, 62 sont destinées à appliquer un champ électrostatique sur deux portions distinctes de chaque pilier 3, permettant de former deux vannes permettant permettre ou bloquer le passage d'électrons dans le pilier 3 vers la boîte quantique disposé à sa verticale ou à partir de celle-ci. Pour cela, les lignes et colonnes 61, 62 forment avantageusement, avec les diélectriques de flanc 41, deux grilles distinctes au niveau de chaque pilier 3. Afin d'améliorer le couplage des ligne et colonne de couplage 61, 62 avec le pilier 3, il est préférable que la ligne de couplage 61 entoure une première portion annulaire du diélectrique de flanc 41 du pilier 3 et que la colonne de couplage 62 entoure une deuxième portion annulaire du diélectrique de flanc 41 du pilier 3. Les première et deuxième portions annulaires sont préférentiellement placée l'une au-dessus de l'autre (c'est-à-dire selon la direction Z dans la figure 1).

La modulation du champ électrique au niveau de deux portions annulaires distinctes permet de former deux vannes électrostatiques. Les deux vannes doivent être « ouvertes » simultanément pour qu'un électron puisse transiter par le pilier 3. Dans tous les autres cas (une seule des deux ouverte ou les deux vannes fermées), le passage est bloqué. Ce principe permet d'adresser individuellement un pilier 3 (et donc la boite quantique correspondante) avec un minimum d'électrodes de couplage 61, 62.

Les lignes de couplage 61 s'étendent parallèlement à la face avant 2a. Les lignes de couplage 61 sont agencées parallèlement les unes par rapport aux autres. Pour éviter les courts-circuits, les lignes sont distantes les unes des autres. De plus, elles sont agencées pour que chaque ligne 61 soit en contact avec le diélectrique de flanc 41 d'au moins un pilier 3. Dans le mode de réalisation de la figure 1, chaque ligne 61 s'étend sur l'espaceur 42 qui s'étend lui-même sur la face avant 2. Elles sont également parallèles les unes aux autres. Dans le mode de réalisation de la figure 1, les piliers 3 sont agencés en quinconce selon les directions X et Y. Chaque ligne 61 s'étend également selon la direction Y et entoure (en étant en contact) une portion annulaire du diélectrique de flanc 41 de plusieurs piliers 3, à la base 31 de chaque pilier 3.

Les colonnes de couplage 62 s'étendent également parallèlement à la face avant 2a. Elles sont également parallèles les unes aux autres. Les colonnes 62 s'étendent également dans un plan qui est distant du plan dans lequel s'étendent les lignes de couplages 61. Dans le mode de réalisation de la figure 1, les colonnes 62 sont enrobées dans un matériau isolant 5, tel qu'un diélectrique, séparant les colonnes 62 des lignes 61. Les colonnes de couplage 62 croisent les lignes de couplage 61 perpendiculairement, à plus ou moins 20° près.

Les colonnes 62 sont également agencées pour que chaque colonne 62 soit en contact avec le diélectrique de flanc 41 d'au moins un pilier 3. Dans le mode de réalisation de la figure 1, chaque colonne 62 s'étend selon la direction X et entoure (en étant en contact) une portion annulaire du diélectrique de flanc 41 de plusieurs piliers 3, à distance de la base 31 de chaque pilier 3.

Ainsi, le réseau de couplage 6 est formé par des lignes et des colonnes de couplage 61, 62 se croisant de manière sensiblement perpendiculaire, c'est-à-dire perpendiculaire à +/- 20° près.

Dans le mode de réalisation de la figure 1, les lignes de couplage 61 s'étendent contre directement contre l'espaceur 42. Elles pourraient, dans un mode de réalisation alternatif, être distantes de l'espaceur 42, entourant une portion annulaire de chaque pilier 3 qui serait disposée entre la base 31 des piliers 3 et la tête 32 des piliers 3. Dans un autre mode de réalisation alternatif, les lignes de couplage 61 pourraient être au-dessus des colonnes de couplage 62 (en considérant le haut comme étant la direction Z croissante). Les colonnes de couplages 62 seraient alors disposées entre l'espaceur 42 (mais préférentiellement à distance de celui-ci) et le plan dans lequel s'étendent les lignes de couplage 61.

Les lignes et colonnes de couplages 61, 62 sont réalisées dans un matériau conducteur, par exemple en métal (TiN, W) ou en silicium dopé polycristallin.

Le rôle du réseau de contrôle 7 a pour but de contrôler le potentiel électrostatique dans la couche qubits 2, alors que le rôle du réseau de couplage 6 a pour but de contrôler le potentiel électrostatique dans les piliers 2. Ceci permet de créer les boîtes quantiques à même de recevoir un qubits. La particularité du circuit 1 est que le réseau de contrôle 7 est disposé du même côté que le réseau de couplage 6. Ceci permet de facilité la fabrication et l'alignements des réseaux entre eux, réduisant notamment la variabilité qui peut être observée entre deux circuits 1. Pour cela, le réseau de contrôle 7 comprend des troisièmes électrodes 71 dites « lignes de contrôle » et des vias conductrices 72 dites « vias de contrôle ».

Les lignes de contrôle 71 sont des lignes conductrices qui forment, avec l'espaceur 42, des grilles au niveau de la couche qubits 2. Pour cela, elles s'étendent parallèlement à la face avant 2a de la couche qubits 2 et directement sur l'espaceur 42. Ainsi, les lignes de contrôle 71 ne sont espacées de la couche qubits 2, que par l'épaisseur de l'espaceur 42. Les lignes de contrôlé 71 forment, avec les portions de l'espaceur 42 disposées entre les lignes 71 et la couche qubits 2, des grilles au niveau de la couche qubits 2. Le couplage de ces grilles peut être déterminée par l'épaisseur, mesurée perpendiculairement à la face avant 2a, de l'espaceur 42.

De manière avantageuse, et tel que présenté dans les figures 1 à 3, les lignes de contrôles 71 s'étendent parallèlement aux lignes de couplage 61. Elles sont notamment distantes des lignes de couplage 61 et des colonnes de couplage 62. Les lignes de contrôle 71 diffère des lignes de couplage en ce qu'elles sont distantes des piliers 3 et notamment des diélectriques de flanc 41 des piliers 3. Ainsi, elles n'influencent pas, ou sinon de façon négligeable, le potentiel électrostatique dans les piliers 3.

Les vias de contrôle 72 sont des électrodes conductrices qui forment également des grilles au niveau de la couche qubits 2. À la différence des lignes de contrôle 71 (ou des lignes de colonnes de couplage 61, 62), les vias 72 s'étendent perpendiculairement à la face avant 2a de la couche qubits 2. Elles s'insèrent ainsi sans peine dans les réseaux de couplage et de contrôle 6, 7 qui sont imbriqués l'un dans l'autre. Dans le mode de réalisation des figures 1 à 3, les vias s'étendent selon la direction Z.

Chaque via 72 présente des première et deuxième extrémités 721, 722, dites « base » et « tête », opposées l'une à l'autre. Chaque via 72 s'étend alors vers la couche qubits 2 de sorte que la base 721 dudit via 72 soit à proximité de la face avant 2a, sans toutefois réaliser de contact électrique avec cette dernière. Grâce à la proximité de la base 721 et de la couche qubits 2, le via 72 peut moduler le potentiel électrostatique dans la couche qubits 2.

Dans un premier développement, les bases 721 des vias 72 sont directement en contact avec l'espaceur 42. La base 721 est par exemple en contact avec l'espaceur 42 et la tête 722 est disposée à l'aplomb de la première extrémité 721. L'espaceur 42 isole électriquement les vias 72 de la couche qubits 2. L'épaisseur de l'espaceur 42 impose ainsi une distance entre la base 721 des vias 72 et la couche qubits 2.

Dans le mode de réalisation des figures 1 à 3, les vias 72 peuvent être entourés d'une couche isolante 724 qui enrobe le flanc 723 des vias 72 et s'étend entre la base 721 des vias 72 et la couche qubits 2. La couche isolante 724 isole les vias 72 de la couche qubits 2. Elle peut être formée à partir d'un matériau diélectrique tel que le SiO₂. Cette couche isolante 724 peut présenter une épaisseur environ inférieure à 10 nm, par exemple de 3 nm.

Afin de pouvoir former un agencement rectangulaire de boîtes quantiques dans la couche qubits 2, chaque ligne de contrôle 71 est disposée entre deux lignes de couplage 61 consécutives et chaque via de contrôle 72 est disposé entre deux colonnes de couplage 62 consécutives.

De manière préférée, chaque via 72 peut s'étendre perpendiculairement à la face avant 2a, depuis la face avant 2a (mais sans contact électrique avec elle), en traversant, sans contact électrique, une des lignes couplages 61. Par exemple, dans le mode de réalisation des figures 1 à 3, les lignes de couplage 62 s'étendent le long de la direction Y, en joignant des piliers 3 qui sont agencés selon cette direction. Les lignes de couplages 62 entourent alors la base 721 des vias 72 qui sont également disposés entre les piliers 3. Afin d'éviter tout court-circuit, la couche isolante 724 entoure le flanc 723 de chaque via 72, au moins au niveau de la portion de flanc 723 en regard de la ligne de couplage 61.

Les vias 72 sont préférentiellement distants des colonnes de couplage 62, des lignes de contrôle 71 et des diélectriques de flanc 41 des piliers 3.

Les têtes 722 d'une pluralité de vias 72 peuvent être connectées électriquement entre elles. Les vias 72 connectées sont par exemple les vias 72 qui sont alignées selon une direction parallèle à la face avant 2a et perpendiculaire aux lignes de couplage 61. Dans les figures 1 à 3, il s'agit des vias 71 alignés selon la direction X.

Le circuit 1 comprend préférentiellement des quatrième électrodes 81 dites « électrodes de lecture » qui permettent de déterminer l'état de charge des boîtes quantiques qui se trouveraient à la verticale des piliers 3. Chaque ligne de lecture 81 est en contact direct avec le flanc 33 d'au moins un pilier 3. Les lignes de lecture 81 s'étendent préférentiellement dans un plan parallèle à la face avant 2a de la couche qubits 2, ledit plan étant proche des têtes 32 des piliers 3. Par proche, on entend à +/-20 nm près, mesuré perpendiculairement à la face avant 2a. Les lignes de lecture 81 s'étendent préférentiellement parallèlement aux lignes de couplage 61. Toutefois, à la différence de ces dernières, les lignes de lecture 81 peuvent être électriquement connectées entre elles. Elles connectent également une pluralité de piliers 3 (par l'intermédiaire de leur flanc 33).

Les diélectriques de flanc 41 peuvent être formés de manière à ne recouvrir qu'une partie de la hauteur des piliers 3, laissant dépasser la tête 32 des piliers 3 et une partie 330 de chaque flanc 33 au voisinage de la tête 32, dite « surface de contact ». Les lignes de lectures 81 sont avantageusement directement connectées à ces surfaces de contact 330 des flancs 33 des piliers 3.

Le circuit 1 comprend préférentiellement des structures de grilles 82, dites « grilles de chargement » qui permettent d'initialiser les qubits dans les boîtes quantiques à l'aplombs des piliers. Ces grilles de chargement 82 sont directement connectées sur la tête 32 d'au moins un pilier 3 voire de plusieurs piliers 3. Une grille de chargement comprend un conducteur, par exemple en métal, et une couche isolante formée, par exemple, dans un oxyde. Le conducteur est disposé en regard de la tête 32 d'un pilier 3 (ou d'une pluralité de piliers 3) et isolé de ces derniers au moyen de la couche isolante.

Dans le mode de réalisation des figures 1 à 3, les lignes de lectures 81 sont disposées de manière à entourer la surface de contact 330 du flanc 33 des piliers 3 tout en laissant libre la tête 32 en tant que tel des piliers 3. Les lignes de lectures forment d'ailleurs des puits autour de la tête 32 des piliers 3, le fond des puits correspondant à la tête 32 des piliers 3. Les grilles de chargement 82 remplissent ces puits. La couche isolante précité tapisse les bords et le fond des puits et le conducteur comble l'espace laissé libre.

Dans le mode de réalisation de ces figures, chaque grille de chargement 82 s'étend selon la direction X et connecte la tête des piliers 3 qui sont alignés selon cette direction.

Le circuit 1 comprend préférentiellement une couche isolante 5 qui s'étend sur l'espaceur 42. La couche isolante 5 s'étend sur l'espaceur 41 et entoure les parties des piliers 3 laissées libres par les lignes et colonnes de couplages 61, 62 ainsi que par les lignes de lecture 81 et grilles de chargement 82. Elle enrobe également les lignes et colonnes de couplage 61, 62 ainsi que les lignes et vias de contrôle 71, 72. Bien entendu, lorsque les lignes de couplages 61 et lignes de contrôle 71 s'étendent contre l'espaceur 42, la couche isolante 5 recouvre ces dernières, sans s'intercaler entre ces lignes 61, 71 et l'espaceur 42. La couche isolante 5 peut être réalisée en matériau diélectrique tel que le SiO₂.

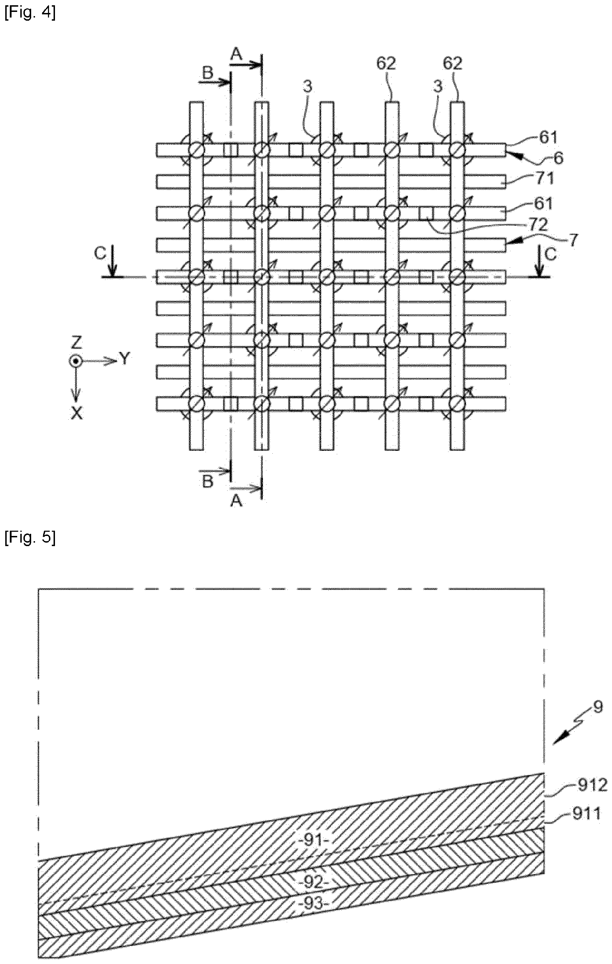

La figure 4 montre un schéma équivalent du circuit 1 présenté dans les figures 1 à 3. La couche qubits 2 n'est pas matérialisée mais un agencement des boîtes quantiques qui peuvent être formée dans la couche qubits 2 est représenté par des ronds avec un flèche (pour matérialiser un qubits).

Les piliers 3 sont agencés en quinconce. Les lignes de couplages 61 et les colonnes de couplages 62 sont agencées en se croisant, avec un pas constant et connectent les piliers selon qui sont alignés selon, respectivement, les directions Y et X. Les lignes de contrôles s'étendent parallèlement aux lignes de couplages 62, à équidistance des lignes de couplages 61 voisines. Les vias 72, dont la base est représentée sont disposés selon un réseau carré. Chaque via 72 (la base 721 de chaque via 72) étant disposé à équidistance des lignes de contrôle 71 et des colonnes de couplage 62. Chaque via 72 est matérialisé sur les lignes de couplage 61. Il faut comprendre par-là que les vias 72 traversent les lignes de couplages 62, sans contact électrique. Cet agencement des réseaux de couplage et de contrôle 6, 7 permet de former des boîtes quantiques selon un maillage carré. La moitié des boîtes quantiques sont disposées sous un pilier 3 et l'autre moitié est distante de ces piliers 3.

Les figures 1 à 3 montrent des coupes A-A, B-B et C-C dont les plans sont montrés dans la figure 4.

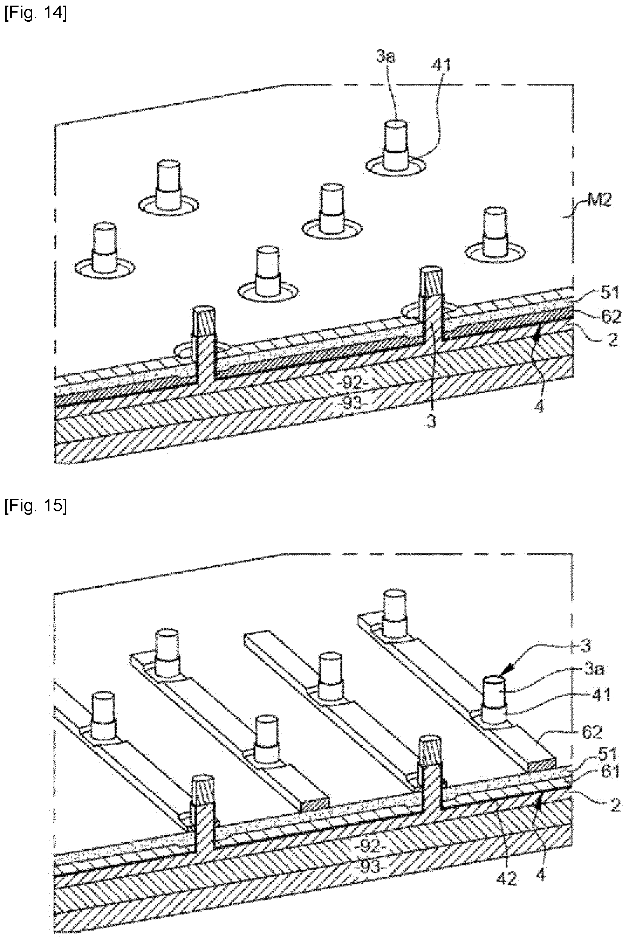

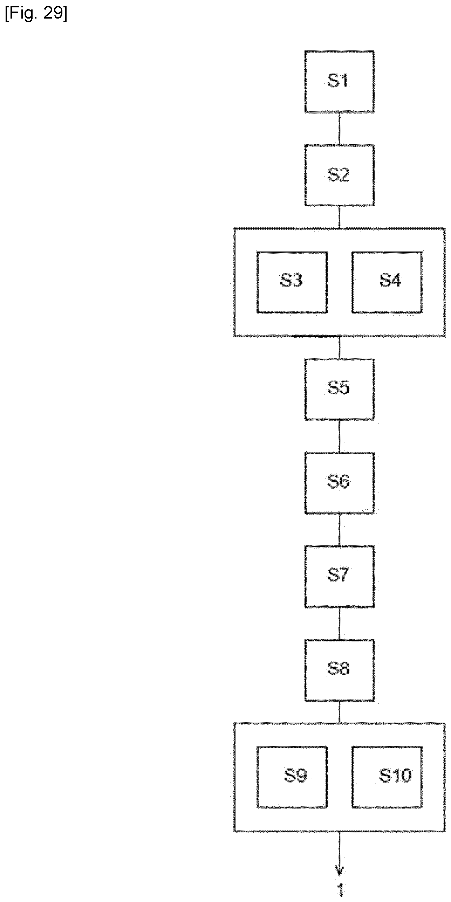

Les figures 5 à 28 présentent schématiquement un mode de mise en oeuvre d'un procédé de fabrication selon l'invention, permettant d'obtenir un circuit 1 électronique selon les figures 1 à 3. Les étapes sont matérialisées par le schéma de la figure 29. Le procédé comprend les étapes suivantes :
- former S1 les piliers 3 ; et la couche qubits 2, ladite couche qubits 2 présentant une face arrière 2b et une face avant 2a, les piliers étant en contact avec la face avant 2a de la couche qubits 2 ;
- oxyder S2 le flanc de chaque pilier 3 et de la face exposée (qui correspond à la face avant 2a) de la couche qubits 2 de manière à former une couche diélectrique 4. La couche diélectrique 4 comprend :
   - une première portion 41 qui correspond à l'espaceur 42, s'étendant sur la face avant 2a de la couche qubits 2 et entourant la base 31 de chaque pilier 3 ; et
   - des deuxièmes portions 42 qui correspondent aux diélectriques de flanc qui entourent le flanc 33 de chaque pilier 3 ;
- former S3 les lignes de couplage 61, parallèles les unes aux autres et s'étendant parallèlement à la face avant 2a de la couche qubits 2, chaque lignes de couplage 61 étant en contact avec le diélectrique de flanc 41 d'au moins un des piliers 3 ;
- former S4 les lignes de contrôle 71, parallèles les unes aux autres et parallèles aux lignes de couplages 61 et s'étendant sur l'espaceur 42, chaque ligne de contrôle 71 étant distante des lignes de couplage 61 et des diélectriques de flanc 41 des piliers semiconducteurs 3 ;
- former S6 les colonnes de couplage 62, parallèles les unes aux autres et perpendiculaires aux lignes de couplage 61, s'étendant parallèlement à la face avant 2a de la couche qubits 2 et distantes des lignes de couplage 61 et des lignes de contrôle 71, chaque colonne de couplage 62 étant en contact avec le diélectrique de flanc 41 d'au moins un des piliers semiconducteurs 3 ;
- former S10 les vias de contrôle 72, distants des colonnes de couplage 62, des lignes de contrôle 71 et des diélectriques de flanc 41 des piliers semiconducteurs 3, chacun des vias de contrôle 72 s'étendant perpendiculairement à la face avant 2a de la couche qubits 2, chaque via 72 présentant une première extrémité 721 disposée à proximité de la face avant 2a de la couche qubit 2, sans contact électrique avec la couche qubits 2.

Le procédé permet ainsi de fabriquer le circuit 1 comprenant une couche qubits 2. La couche qubits 2 peut recevoir les qubits pendant leur stockage et leur manipulation.

Le procédé proposé par le document de l'art antérieur FR 3 066 297 comprend une reprise de contact par épitaxie au niveau des boîtes quantiques. Toutefois, une croissance par épitaxie peut provoquer un réajustement cristallin et/ou l'apparition de défaut à l'interface entre la couche de démarrage et la couche épitaxiée. Le procédé selon l'invention permet d'obtenir la couche qubits 2 et les piliers 3 gravés dans la même première couche semiconductrice 91, c'est à dire dans le même cristal. Ladite gravure permet de délimiter la pluralité de piliers 3 et la couche qubits 2 tout en conservant une continuité cristalline entre la couche 2 et les piliers 3, évitant ainsi l'apparition de défauts ou d'une interface. La continuité cristalline peut être contrôlée par des techniques d'imagerie telles que la microscopie électronique à balayage ou la microscopie électronique à transmission. Un circuit obtenu par le procédé selon l'invention montrerait une absence d'interface entre la couche qubits 2 et les piliers 3. Un circuit obtenu par un procédé de l'art antérieur montrerait des défauts ou une interface entre la couche qubits et les piliers.

Le procédé selon l'invention permet également de simplifier la fabrication des circuits en réduisant le nombre de reports nécessaire pour fabriquer les lignes et colonnes de couplage et la couche qubits. Il permet également de ne pas avoir besoin de retourner la couche qubits 2 pour former le réseau de contrôle 7 et permet ainsi d'éviter un désalignement des réseaux de couplage et de contrôle 6, 7 entre eux.

La formation S1 des piliers 3 et de la couche qubits 2 peut être réalisée au moyen d'une gravure réalisée dans un substrat 9 tel qu'illustré par la figure 5, comportant sur l'une de ces surfaces la première couche semiconductrice 91. La première couche semiconductrice 91 est monocristalline et comprend avantageusement une densité de défauts inférieure à 10⁶ cm⁻³. La première couche semiconductrice 91 présente une épaisseur, mesurée perpendiculairement à la surface libre, préférentiellement supérieure ou égale à 100 nm. L'épaisseur de la première couche semiconductrice 91 permet de graver ladite couche 91 de manière à former la couche qubits 2 tout en s'assurant que les piliers 3 soient suffisamment hauts pour dépasser les lignes et colonnes de couplage 61, 62. L'épaisseur de la première couche semiconductrice 91 peut être réduite ou augmentée selon que le circuit 1 à fabriquer comporte plus ou moins de lignes/colonnes de couplage. Par exemple, des troisièmes électrodes conductrices, formant par exemple des diagonales de couplage, pourraient être ajoutées, nécessitant des piliers 3 plus grands.

Comme mentionné précédemment, la première couche semiconductrice 91 est en silicium monocristallin afin d'être compatible avec des procédés de fabrication standard dans le domaine. Le silicium de la première couche semiconductrice S1, s'il y a lieu, peut également être enrichi par un isotope tel que le silicium 28. Ce dernier permet d'augmenter le temps de cohérence intrinsèque des qubits. La concentration de silicium 28 dans la première couche semiconductrice 91 est par exemple supérieure à 99,9 %.

La première couche semiconductrice 91 peut être obtenue à partir d'un substrat 9, par exemple de type SOI, comprenant une couche semiconductrice monocristalline en face avant 911, une couche semiconductrice en face arrière 93 et une couche isolante 92. La couche isolante est disposée entre les deux couches précédentes 911, 93, autrement dit enterrée sous la couche semiconductrice en face avant 911. Une épitaxie à partir de la couche semiconductrice monocristalline en face avant 911 permet d'obtenir une couche semiconductrice épitaxiée 912. La couche semiconductrice monocristalline en face avant 911 et la couche semiconductrice épitaxiée 912 forment ainsi la première couche semiconductrice 91. Une épitaxie réalisée de préférence en pleine plaque permet de conserver la qualité cristalline de la couche semiconductrice en face avant 911 et ainsi obtenir une première couche semiconductrice 91 monocristalline. De plus, réaliser une épitaxie permet de contrôler l'épaisseur de la couche semiconductrice épitaxiée 912 et donc l'épaisseur de la première couche semiconductrice 91 sans recourir à une étape de gravure. La première couche semiconductrice 91 comprend alors la couche semiconductrice épitaxiée 912 et la couche semiconductrice en face avant 911. Il est préférable que la première couche semiconductrice 91 présente une bonne qualité cristalline afin de fabriquer un circuit électronique quantique présentant de bonnes caractéristiques électroniques et une faible variabilité. C'est la raison pour laquelle il est préférable que la première couche semiconductrice soit obtenue en partie par épitaxie.

La couche semiconductrice épitaxiée 912 peut également être amincie si elle est trop épaisse. Une méthode bien connue de la personne du métier, telle que des étapes successives d'oxydation/gravure, peut être mise en oeuvre.

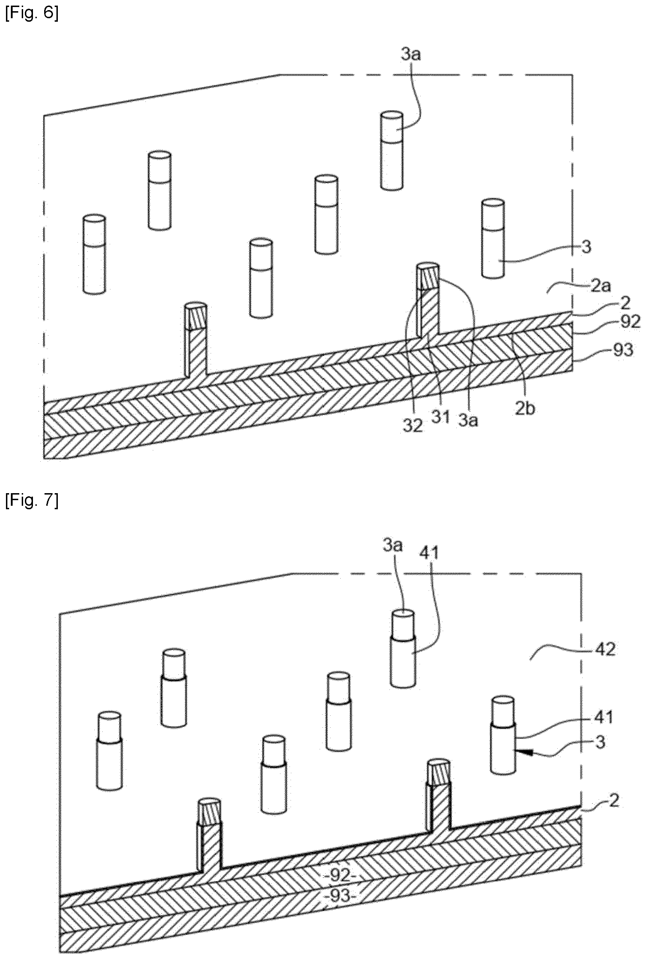

La figure 6 illustre la formation S1 de la première couche semiconductrice S1 de manière à obtenir les piliers 3 et la couche qubits 2. Pour cela, une première partie de la première couche semiconductrice 91 est gravée afin d'obtenir le circuit intermédiaire illustré en figure 6. Afin d'obtenir la pluralité de piliers 3, ladite gravure est avantageusement réalisée de manière anisotrope, c'est à dire selon une direction préférentielle, préférentiellement perpendiculaire à la surface libre de la première couche semiconductrice 91. Des plots de protection 3a, dits « masques durs », peuvent être disposés sur la surface de la première couche semiconductrice 91, pour protéger une partie de ladite couche et permettre de former un pilier 3 sous chacun des plots de protection 3a.

Un agencement particulier des qubits au sein de la couche qubits dans le circuit en fonctionnement permet de mettre en oeuvre une méthode de correction d'erreurs appelée « surface code ». Pour cela, les qubits sont préférentiellement agencés selon un réseau carré présentant un pas donné. Une première partie des qubits est destinée à former des qubits de données et une seconde partie des qubits est destinée à former des qubits de mesure. Les qubits de données et de mesure sont disposés de manière alternée formant ainsi un réseau de qubits de données en quinconce et un réseau de qubits de mesure en quinconce. Les réseaux de qubits en quinconce présentent ainsi un pas double par rapport au pas du réseau carré. Seul les qubits de mesure sont destinés à être disposés à l'aplomb des piliers 3, il est ainsi avantageux de disposer également ces derniers en quinconce.

La gravure de la première partie de la première couche semiconductrice 91 est également réalisée de manière à conserver une deuxième partie 2 de la première couche semiconductrice 91, formant la couche qubits. Par conserver, on entend que la gravure est par exemple arrêtée avant que toute l'épaisseur de la première couche semiconductrice 91 ne soit gravée. Ladite gravure est réalisée de sorte que l'épaisseur de la couche qubits 2, mesurée parallèlement au sens de la gravure, soit préférentiellement comprise entre 5 nm et 35 nm, de préférence entre 10 nm et 20 nm, par exemple égale à 15 nm. La couche qubits présente une face avant 2a et une face arrière 2b. La face arrière 2b est la face orientée vers la couche enterrée 92. La face avant 2a est préférentiellement plane.

Les piliers 3, tels qu'illustrés par la figure 6, reposent ainsi sur la face avant 2a de la couche qubits 2. La base 31 (c'est-à-dire l'une des deux extrémités) de chaque pilier 3 repose sur la couche qubit 2. La tête 32 de chaque pilier 3 est préférentiellement disposée sous un plot de protection 3a. La gravure de la première couche semiconductrice 91 permet ainsi d'obtenir une continuité cristalline entre les piliers 3 et la couche qubits 2 au niveau de chaque base 31 des piliers 3. La première couche semiconductrice 91 étant monocristalline, la couche qubits 2 et les piliers 3 sont donc réalisés dans le même cristal. Chaque pilier 3 peut présenter une hauteur, mesurée perpendiculairement à la couche qubits 2, depuis la base dudit pilier 3 jusqu'à sa tête, supérieure à 50 nm et préférentiellement supérieure ou égale à 80 nm.

Chaque pilier 3 peut présenter un ou plusieurs flancs 33 selon que ce dernier soit cylindrique ou parallélépipédique. Afin de simplification dans le reste de la description, il ne sera fait mention que « du flanc » d'un pilier 3 pour désigner le flanc ou les flancs dudit pilier 3, selon que ce dernier soit cylindrique ou parallélépipédique. Lorsque la gravure met en oeuvre des plots de protection 3a, le flanc 33 de chaque pilier 3 est ainsi disposé à l'aplomb du pourtour de chaque plot de protection 3a. Le diamètre de chaque pilier 3, mesuré selon un plan parallèle à la face avant 2a de la couche qubits 2, peut coïncider avec le diamètre de chaque plot de protection 3a et est par exemple compris entre 30 nm et 60 nm, par exemple égal à 50 nm. Le diamètre de chaque pilier 3 peut également être inférieure au diamètre de chaque plot de protection 3a, notamment lorsque la gravure mise en oeuvre n'est pas totalement anisotrope. Ainsi le flanc de chaque pilier 3a est légèrement en retrait de l'aplomb du pourtour de chaque plot 3a.

Le procédé comporte avantageusement, avant la gravure de la première couche semiconductrice 91, la formation de la pluralité de plots de protection 3a sur la première couche semiconductrice 91. Les plots de protection 3a sont préférentiellement formés par dépôt d'une couche de masque dur, suivi de la photolithographie d'un masque de résine et gravure anisotrope des plots 3a à travers le masque de résine. Les plots de protection 3a peuvent également être formés par photolithographie d'un masque de résine et dépôt d'une couche dite de masque dur, par exemple de SiN. De préférence, les plots de protection 3a présentent un contour pouvant être circulaire ou rectangulaire. Chaque plot de protection 3a présente une hauteur, mesurée perpendiculairement à la surface libre de la première couche semiconductrice 91, pouvant être comprise entre 20 nm et 80 nm. Lorsque les plots de protection 3a sont cylindriques, ils présentent chacun un diamètre, mesuré parallèlement à la surface libre de la première couche semiconductrice 91, pouvant être compris entre 30 nm et 60 nm. Lorsque les plots de protection 3a sont parallélépipédiques, ils présentent chacun une diagonale pouvant être compris entre 30 nm et 60 nm. Afin de simplification dans la description, on désignera par « diamètre » tant le diamètre des plots cylindriques que la diagonale des plots parallélépipédiques.

Afin de former les piliers 3 en quinconce par rapport au réseau de qubits, il est avantageux de disposer les plots de protection 3a en quinconce sur la première couche semiconductrice 91.

Lorsque le procédé est réalisé sur un substrat de type SOI, la couche qubits 2 s'étend alors sur la couche enterrée 92 (qui est isolante) et plus particulièrement entre la pluralité de piliers 3 et la couche enterrée 92.

La figure 7 illustre une première mise en oeuvre de l'oxydation S2 du flanc 33 de chaque pilier 33 et de la face avant 2a de la couche qubits. Ladite oxydation S2 est réalisée de manière à former une couche diélectrique 4 continue et présentant une épaisseur sensiblement constante, c'est-à-dire constante à 20 % près, voire 10 % près. La couche diélectrique 4 est formée au niveau de chaque flanc 33 et sur la face avant 2a de la couche qubits 2.

La couche diélectrique 4 présente une première portion 41 qui forme l'espaceur 41 sur lequel pourront s'étendre les lignes de couplage 61 et les lignes de contrôles 71. L'espaceur 41 s'étend sur la face avant 2a de la couche qubits 2 et entoure la base 31 de chaque pilier 3. L'espaceur 41 est considéré comme étant plan même s'il peut s'écarter un peu de cette définition au niveau de la base 31 des piliers 3. L'espaceur 41 montre en revanche une épaisseur, mesurée perpendiculairement à la face avant 2a, sensiblement constante et inférieure à 10 nm.

La couche diélectrique 4 présente des premières portions 41, formant les diélectriques de flanc. Chaque pilier 3 est ainsi entouré d'un diélectrique de flanc 41. Ladite oxydation S2 est préférentiellement réalisée par oxydation thermique. De cette manière, un diélectrique de flanc 41 enrobe complètement le flanc de chaque pilier 3. De même que l'épaisseur de l'espaceur 42, l'épaisseur de chaque diélectrique de flanc 41, mesurée perpendiculairement à la surface libre, est préférentiellement comprise entre 5 nm et 10 nm. Une oxydation thermique forme un oxyde de meilleur qualité qu'un oxyde déposé. Il est donc avantageux de former l'espaceur 42 et les diélectriques de flanc 41 de cette manière.

L'oxydation thermique a pour effet de transformer une partie du matériau semiconducteur de chaque pilier 3 en matériau diélectrique. L'interface entre le matériau semiconducteur et le diélectrique de chaque pilier 3 n'est pas à l'aplomb du plot de protection 3a mais légèrement en retrait, rapprochée du centre de chaque pilier 3. L'interface entre le matériau semiconducteur d'un pilier 3 et le diélectrique de flanc 41 est déplacée d'une distance comprise entre 5 nm et 10 nm par rapport à l'aplomb du plot de protection 3a, en direction du centre dudit pilier 3. Le retrait de l'interface par rapport à l'aplomb permet de protéger le matériau semiconducteur du pilier 3lors des étapes suivantes du procédé, notamment les étapes mettant en oeuvre une gravure anisotrope. Ainsi, l'intégrité cristalline du pilier 3 et ses propriétés cristallines sont préservées. De plus, une partie du diélectrique de flanc 41 est masquée par le plot de protection 3a et est ainsi protégée des étapes suivantes de gravure. Une oxydation thermique forme un oxyde de meilleure qualité, il est donc avantageux de conserver un tel oxyde au niveau du flanc de chaque pilier 41.

En revanche, le volume de matériau oxydé peut croître lors de l'oxydation thermique, si bien que la surface libre de chaque diélectrique de flanc 41 peut être distante de l'aplomb du plot de protection 3a et légèrement exposée par rapport audit plot 3a. Ainsi, les étapes suivantes du procédé, mettant en oeuvre une gravure anisotrope, peuvent également graver la partie exposée dudit diélectrique de flanc 41.

Les lignes et colonnes de couplage 61, 62, réalisée dans un deuxième temps, forment avec chaque diélectrique de flanc 41, une grille au niveau de chaque pilier 3. Il est donc avantageux, pour réduire la variabilité des circuits fabriqués, de contrôler l'épaisseur de chaque diélectrique de flanc 41. Il est plus aisé de contrôler l'épaisseur de chaque diélectrique de flanc 41 pendant leur formation, c'est à dire pendant l'étape d'oxydation S2, que lors d'une gravure anisotrope.

Une variante de mise en oeuvre de l'étape d'oxydation S2 permet d'améliorer la variabilité des circuits 1 fabriqués. Selon cette variante, l'étape d'oxydation S2 comprend une première sous-étape d'oxydation du flanc 33 de chaque pilier 3 de manière à former, au niveau du flanc de chaque pilier 3, une première couche diélectrique sacrificielle. Cette couche sacrificielle est également formée sur la face avant 2a de la couche qubits 2. Chaque première couche diélectrique sacrificielle est ensuite retirée lors d'une deuxième sous-étape, préférentiellement par gravure isotrope, pour libérer la surface libre de chaque pilier 3. Enfin, une troisième sous-étape d'oxydation S23 de la surface nouvellement libérée de chaque pilier 3 permet ainsi de former, au niveau du flanc 33 de chaque pilier 3, un diélectrique de flanc 41 final. Grâce à la gravure de la première couche sacrificielle et la réoxydation S23 du flanc des piliers 3, la surface libre de chaque diélectrique de flanc 41 est à l'aplomb du plot de protection 3a, ou légèrement en retrait. Ainsi, les étapes suivantes du procédé, pouvant mettre en oeuvre une gravure anisotrope, ne détériorent pas ou n'amincissent pas les diélectriques de flanc 41. De cette manière, la variabilité de comportement des grilles formées avec les lignes et colonnes de couplage 61, 62 est réduite. De plus, la réoxydation S23 permet également de reformer l'espaceur 42 final sur la face avant 2a de la couche qubits 2.

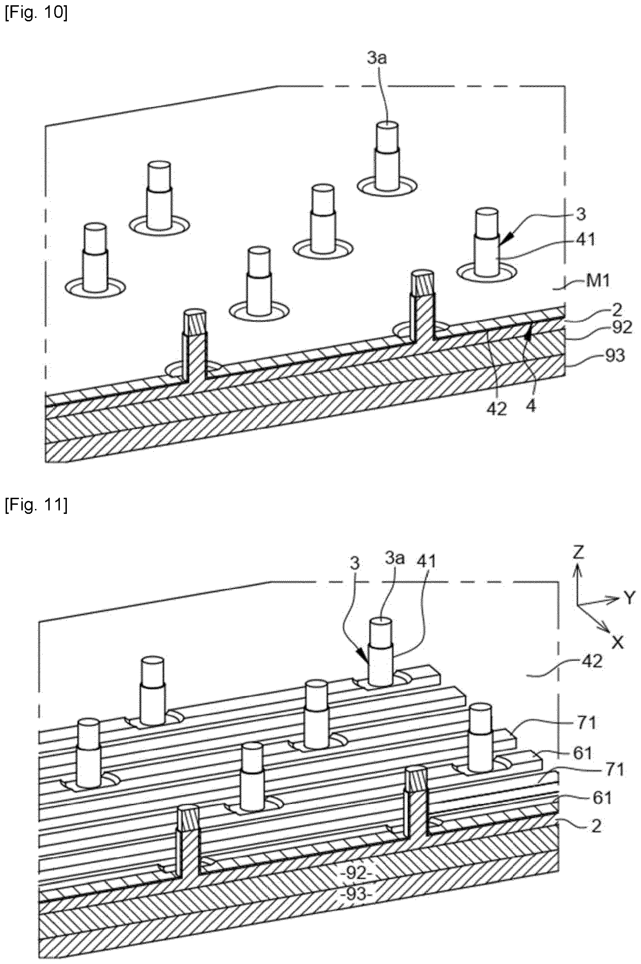

Le procédé comprend une étape de formation S3 des lignes de couplage 61. La structure résultante est illustrée par la figure 11. Les lignes de couplage 61 sont destinées à appliquer un champ électrostatique sur chaque première portion de pilier 3 dépassant de l'espaceur 42, permettant de permettre ou bloquer le passage d'électrons dans le pilier 3 vers le qubit ou à partir du qubit. Pour cela, elles forment avantageusement, avec les diélectriques de flanc 41, une grille au niveau d'une portion du pilier 3. Afin d'améliorer le couplage de chaque ligne de couplage 61 avec un pilier 3, il est préférable que chaque ligne de couplage 61 entoure une première portion annulaire du diélectrique de flanc 33 du pilier 3. Pour cela, chaque ligne de couplage 61 est en contact avec le diélectrique de flanc 41 entourant au moins un pilier 3. De préférence, chaque ligne de couplage 61 est formée S3 de manière à s'étendre sur l'espaceur 41, de manière à entourer une première portion annulaire d'au moins un diélectrique de flanc 41 dépassant de l'espaceur 41. Chaque ligne de couplage 61 est en contact avec au moins un diélectrique de flanc 41. Chaque ligne de couplage 61 peut également être en contact avec une pluralité de diélectriques de flanc 41. De la sorte, une ligne de couplage 61 peut appliquer un champ électrostatique sur plusieurs piliers 3. En combinaison avec les colonnes de couplage (décrites ci-après), elle permet l'indexation de chaque pilier 3 et donc de chaque qubit de manière indépendante. Les piliers 3 étant disposés en quinconce, chaque ligne de couplage 61 peut contacter plusieurs diélectriques de flanc 41 en s'étendant selon la direction Y, coïncidant avec une ligne de piliers 3. La figure 11 illustre une vue 3D des piliers 3 et des lignes de couplages 61 obtenues à l'issue de leur formation S3. Les piliers sont agencés en quinconce formant des lignes selon la direction Y et des colonnes selon la direction X.

Le procédé comprend également une étape de formation S4 des lignes de contrôle 71. La structure résultante illustrée par la figure 11 comprend d'ailleurs également les lignes de contrôle 71. En fait, les étapes de formations S3, S4 des lignes de couplages 61 et de contrôle 71 peuvent être réalisées de manière concomitante en parallèle. On parle alors de formation conjointe S3, S4. Il en résulte alors que les lignes de couplages 61 et les lignes de contrôle 71 réalisées s'étendent dans un même plan, parallèlement à la face avant 2a de la couche qubits 2, et directement contre l'espaceur 42.

Les lignes de contrôle 71 sont parallèles aux lignes de couplage 61 et disposées entre deux lignes de couplage 61 consécutives selon la direction X. Les lignes de contrôle 71 ne sont pas en contact avec les diélectriques de flanc 41 des piliers 3, et sont même distantes de ces diélectriques 41.

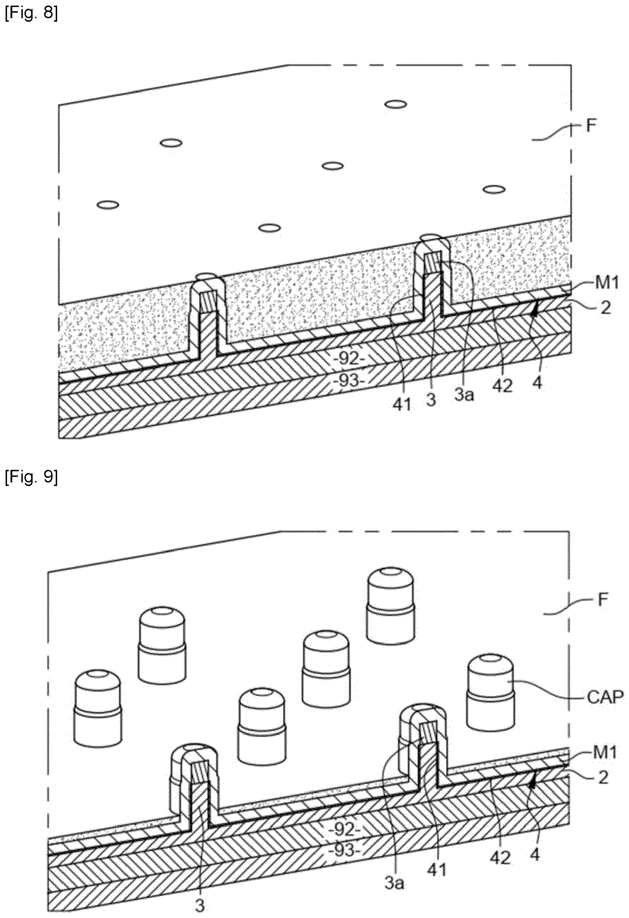

La formation conjointe S3, S4 des lignes de couplage 61 et de contrôle 71 est détaillée par les figures 8, 9 et 10. L'étape de formation S3, S4 peut comprendre un premier dépôt conforme d'une première couche conductrice M1, par exemple en silicium polycristallin dopé ou en nitrure de titane. Le premier dépôt est préférentiellement conforme et permet de recouvrir intégralement l'espaceur 42, les diélectriques de flanc 41 et les plots de protection 3a. La première couche conductrice M1 peut présenter une épaisseur, mesurée perpendiculairement à la couche diélectrique 4, comprise entre 10 nm à 15 nm. L'étape de formation peut comprendre un dépôt d'une couche diélectrique sacrificielle F, par exemple en oxyde de silicium, de manière à recouvrir complètement l'ensemble.

L'étape de formation conjointe peut également comprendre une gravure de la couche diélectrique sacrificielle F, telle qu'illustrée par la figure 9, réalisée de manière anisotrope et sélective par rapport à la première couche conductrice M1. La première gravure permet de mettre à nu une pluralité de portions CAP de la première couche conductrice M1, dites « capuchons ». Chaque capuchon CAP recouvre un plot de protection 3a et une portion supérieure d'un pilier 3. La gravure de la couche diélectrique sacrificielle F est arrêtée de manière à laisser une épaisseur résiduelle de 10 nm à 15 nm, mesurée perpendiculairement à la face avant 2a de la couche qubits 2, à la base de chaque capuchon CAP.

L'étape de formation conjointe peut également comprendre une gravure de la première couche conductrice M1 et de la couche diélectrique sacrificielle F, telle qu'illustrée par la figure 10, de manière à retirer les capuchons CAP ainsi que l'épaisseur résiduelle de la couche diélectrique sacrificielle F. La première couche conductrice M1 restante s'étend alors sur l'espaceur 42 et entoure une première portion annulaire de chaque diélectrique de flanc 41.

La gravure de la première couche conductrice M1 peut être réalisée en une seule fois, par exemple par gravure non sélective et isotrope, permettant de retirer dans un même temps la pluralité de capuchons CAP et l'épaisseur résiduelle de la couche diélectrique sacrificielle F. L'épaisseur résiduelle de la couche diélectrique sacrificielle F est alors avantageusement choisie de sorte qu'elle soit complètement retirée lorsque les capuchons CAP sont retirés.

La gravure peut également être réalisée en deux sous-étapes. Une première sous-étape comprenant une gravure sélective de la première couche conductrice M1 par rapport à l'épaisseur résiduelle de la couche diélectrique sacrificielle F de manière à retirer les capuchons CAP. Une deuxième sous-étape comprenant une gravure anisotrope de l'épaisseur résiduelle de la couche diélectrique sacrificielle F de manière à retirer la couche diélectrique sacrificielle F. N'étant pas réalisée de manière sélective, la deuxième sous-étape est arrêtée avant de graver substantiellement la première couche conductrice M1.

Afin de finaliser les lignes de couplage 61 et les lignes de contrôle 71, telles qu'illustrées par la figure 11, l'étape de formation conjointe S3, S4 peut comprendre la gravure de la première couche conductrice M1 à travers un masque de résine de manière à obtenir les lignes de couplage 61 et les lignes de contrôle 71. L'étape de formation conjointe S3, S4 peut par exemple comprendre, avant ladite gravure, une photolithographie d'un masque de résine sur la première couche conductrice M1, suivi de la gravure de la première couche conductrice M1 à travers le masque de résine de manière à obtenir les lignes de couplage 61 et les lignes de contrôle 71. Les lignes de couplage 61 et les lignes de contrôle 71 sont préférentiellement sensiblement parallèles les unes aux autres et s'étendent préférentiellement selon la direction Y. Par sensiblement parallèle, on entend à ± 30° près, préférentiellement à ± 20° près, voire à ± 10° près.

Selon une variante de la gravure de la première couche conductrice M1, seuls les capuchons CAP sont retirés, par exemple par gravure sélective. L'épaisseur résiduelle de la couche diélectrique sacrificielle F est alors utilisée pour former un masque lors de la sous-étape de photolithographie précitée et permettre ainsi la gravure des lignes 61, 71 à travers ledit masque. La couche diélectrique sacrificielle F est retirée, par exemple par gravure sélective, après l'obtention des lignes 61, 71.

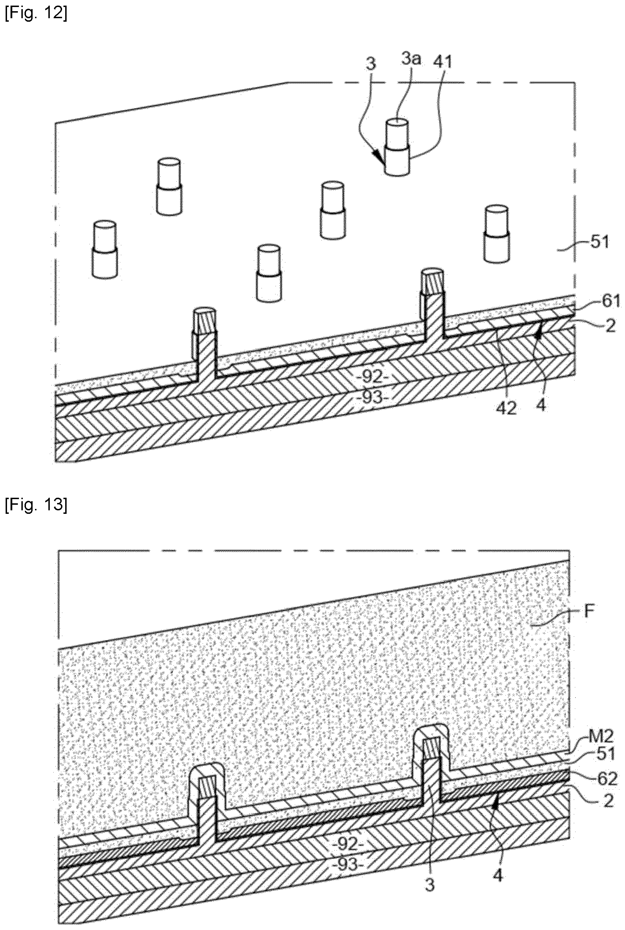

La figure 12 présente schématiquement une étape de dépôt S5 d'une première couche de séparation 51. La première couche de séparation 51 est déposée de manière à recouvrir les lignes de couplage 61 et de contrôle 71, assurant ainsi leur isolation électrique. La première couche de séparation 51 peut également être déposée de manière à recouvrir l'espaceur 42. Le dépôt S5 de la première couche de séparation 51 est avantageusement réalisé à partir d'oxyde de silicium SiO2. Pour cela, la première couche de séparation 51 peut être déposée, dans un premier temps, de manière à recouvrir intégralement les piliers 3 ainsi que les plots de protection 3a. Un aplanissement et une gravure anisotrope de la première couche de séparation 51 permettent de contrôler l'épaisseur de ladite couche 51. L'aplanissement, par exemple par polissage mécanique et/ou chimique, s'arrête au sommet des plots de protection 3a. La gravure de la première couche de séparation 51 aplanie est arrêtée avant d'atteindre les lignes de couplage 61 et de contrôle 71. L'épaisseur finale de la première couche de séparation 51, mesurée perpendiculairement à la face avant 2a et à partir de l'espaceur 42, est alors préférentiellement comprise entre 20 nm et 40 nm. Ainsi, au moins une première portion de chaque pilier 3 dépasse de la première couche de séparation 51. Le dépôt S5 peut être réalisé par dépôt chimique en phase vapeur (ou « CVD » en anglais) et/ou dépôt chimique assisté par plasma. À l'issue de l'étape dudit dépôt, la première couche de séparation 51 recouvre les lignes de couplage 61 et de contrôle 71.

L'épaisseur de la première couche de séparation 51 est préférentiellement choisie de sorte qu'au moins une portion de chaque pilier 3 dépasse de la première couche de séparation 51.

Les figures 13 à 15 illustrent l'étape de formation S6 des colonnes de couplage 62. De la même manière que les lignes de couplage 61, Les colonnes de couplage 62 forment avantageusement, avec les diélectriques de flanc 41, une grille au niveau de chaque pilier 3. Les lignes et les colonnes de couplage 61, 62 sont ainsi destinées à appliquer un champ électrostatique sur deux portions distinctes d'un même pilier 3, permettant d'autoriser ou bloquer le passage d'électrons dans ledit pilier 3. Les lignes et colonnes de couplage 61, 62 sont agencées de sorte qu'appliquer un potentiel électrique à l'une des lignes 61 et l'une des colonnes 62 permet d'autoriser ou bloquer le passage d'électrons d'un seul pilier 3 parmi la pluralité de piliers 3. Les lignes et colonnes de couplage 61, 62 permettent ainsi l'indexation individuelle des qubits pour, par exemple, initialiser ou mesurer leur état.

Il est ainsi également avantageux que le couplage de chaque colonne de couplage 62 avec les piliers 3 soit reproductible et maximal. Il est ainsi préférable que les colonnes de couplage 62 entourent, de la même manière que les lignes de couplage 61, une portion annulaire d'un diélectrique de flanc 41 d'un pilier 3. Pour cela, chaque colonne de couplage 62 est en contact avec au moins un diélectrique de flanc 41. De préférence, chaque colonne de couplage 62 est formée S6 de manière à entourer une portion annulaire d'au moins un diélectrique de flanc 41, dépassant de la première couche de séparation 51.

Les colonnes de couplage 62 s'étendent avantageusement sur la première couche de séparation 51. Elles s'étendent ainsi parallèlement à la face avant 2a de la couche qubits 2. La première couche de séparation 51, recouvrant les lignes de couplage 61 et de contrôle 71, permet d'assurer une isolation électrique entre les lignes et les colonnes 61, 71, 62. Toutefois, il peut subsister un couplage capacitif entre les lignes et les colonnes 61, 71, 62. Afin de réduire le couplage capacitif, il est avantageux que les colonnes de couplage 62 soient réalisées de manière à croiser les lignes de couplages 61 et les lignes de contrôle 71 selon un angle sensiblement droit. Par angle sensiblement droit, on entend droit à ± 30° près, préférentiellement à ± 20° près, voire à ± 10° près.

Ainsi, les colonnes de couplage 62 s'étendent préférentiellement parallèlement entre elles et selon la direction X. Ainsi, elles peuvent contacter les diélectriques de flanc 41 d'une pluralité de piliers 3 alignés selon la direction X et réduire le couplage capacitif avec les lignes de couplages 61 et de contrôle 71.

Les piliers 3 étant agencés en quinconce et formant des lignes et des colonnes selon, respectivement, la direction Y et la direction X, les colonnes de couplages 62 sont alors préférentiellement orientées perpendiculairement aux lignes de couplage 61. Il est toutefois envisageable que les colonnes de couplage 62 forment un autre angle avec les lignes de couplage 61, par exemple égal à 45°. Auquel cas, les deuxièmes électrodes conductrices 62 sont appelées « diagonales de couplage ».

L'étape de formation S6 des colonnes de couplage 62 est préférentiellement similaire à l'étape de formation S3 des lignes de couplage 61 telle qu'illustrée par les figures 8 à 10. Elle fait intervenir le dépôt d'une deuxième couche métallique M2 de manière à former des capuchons CAP sur les piliers 3. L'emploi d'une couche diélectrique sacrificielle F permet alors de retirer, en deux temps les capuchons CAP et former les colonnes 62.

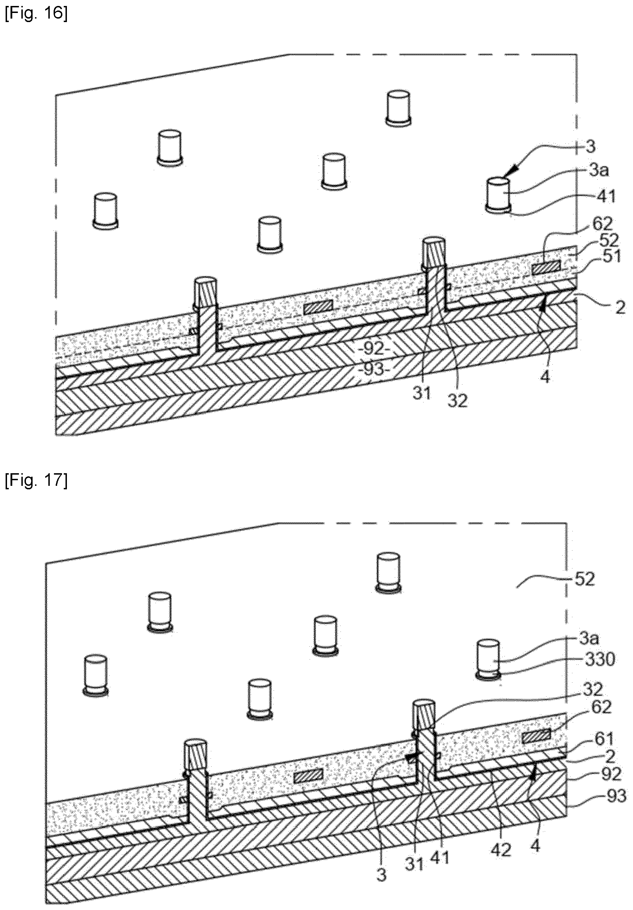

La figure 16 illustre l'étape de dépôt S7 d'une deuxième couche de séparation 52. Ladite deuxième couche de séparation 52 repose sur la pluralité de colonnes de couplage 62 et enrobe ladite pluralité de colonnes 62. Le dépôt S7 de la deuxième couche de séparation 52 peut être réalisée de la même manière que le dépôt S5 de la première couche de séparation 51. La deuxième couche de séparation 52 peut également être réalisée à partir d'oxyde de silicium SiO₂. La deuxième couche de séparation 52 enrobe les colonnes de couplage 62 et peut également recouvrir la première couche de séparation 51. Aussi, la deuxième couche de séparation 52 présente une épaisseur, mesurée à partir de la première couche de séparation 51, comprise entre 20 nm et 40 nm.

L'épaisseur de la deuxième couche de séparation 52 est configurée pour qu'une portion de chaque pilier 3 dépasse de ladite deuxième couche de séparation 52. De la sorte, une troisième portion annulaire de chaque diélectrique de flanc 41, entourant chaque pilier 3, dépasse également de ladite deuxième couche 52. Cette portion annulaire s'étend alors sur toute la hauteur du pilier 3 qui dépassent de la deuxième couche 52, c'est à dire de la surface libre de la deuxième couche 52 jusqu'à la tête 32 de chaque pilier 3, affleurant ainsi les plots de protection 3a posés sur chaque pilier 3. L'épaisseur de la deuxième couche de séparation 52 et/ou la hauteur de chaque pilier 3 est choisie de sorte que la hauteur de la portion dépassant de la couche de séparation 52 soit comprise entre 5 nm et 20 nm inclus, par exemple 10 nm.

Afin d'ajuster l'épaisseur de la deuxième couche de séparation 52, elle peut être, dans un premier temps, déposée de manière à dépasser le sommet des plots de protection 3a. Dans un second temps, elle peut être aplanie jusqu'à affleurer le sommet des plots de protection 3a. Enfin, la deuxième couche de séparation 52 peut être gravée de manière anisotrope afin de mettre à nu les plots de protection 3a et les portions annulaires de chaque diélectrique de flanc 41.

Les figures 17 à 18 illustrent la formation S8 des lignes de lecture 81. Chaque ligne de lecture 81 formée est préférentiellement en contact avec le matériau semiconducteur d'un pilier 3. Afin d'obtenir un bon contact électrique entre les lignes de lecture et les pilier 3, il est avantageux que chaque ligne de lecture 81 soit en contact avec une surface de contact dédiée pour chaque pilier 3. Dans l'exemple de la figure 17, les lignes de lecture 81 s'étendent selon la direction Y et connectent une surface de contact d'une pluralité de piliers 3. Chaque ligne de lecture 81 peut également être en contact avec le flanc d'un plot de protection 3a. Dans l'exemple des figure 17 à 18, les lignes de lecture 81 s'étendent sur la deuxième couche de séparation 52 et recouvrent le chaque plot de protection 3a.

Afin de réduire le couplage capacitif entre les colonnes de couplage 62 et les lignes de lecture 81, ces dernières sont avantageusement orientées perpendiculairement aux colonnes de couplage 62.

La formation S8 des lignes de lecture 81 peut comprendre, dans un premier temps, le retrait du diélectrique de flanc 41 libre, dépassant de la deuxième couche de séparation 52, tel qu'illustré par la figure 17. Ce retrait comprend par exemple la gravure des portions annulaires de chaque diélectrique de flanc 41 dépassant de la deuxième couche de séparation 52, de manière à mettre à nu une portion annulaire 330 au niveau de la tête 32 de chaque pilier 3. Cette portion annulaire 330 peut également être appelée « surface de contact ». La surface de contact 330 peut être utilisée pour connecter électriquement le pilier 3 à une électrode de lecture 81 permettant de lire l'état du qubit situé à l'aplomb dudit pilier 3.

La gravure du diélectrique de flanc 41 est préférentiellement réalisée de manière à les retirer complètement. Pour cela, ladite gravure peut être réalisée sélectivement, au moins par rapport aux plots de protection 3a. Lorsque les diélectriques de flanc 41 sont composés de SiO2, la gravure peut être réalisée au moyen d'acide fluorhydrique HF dilué.

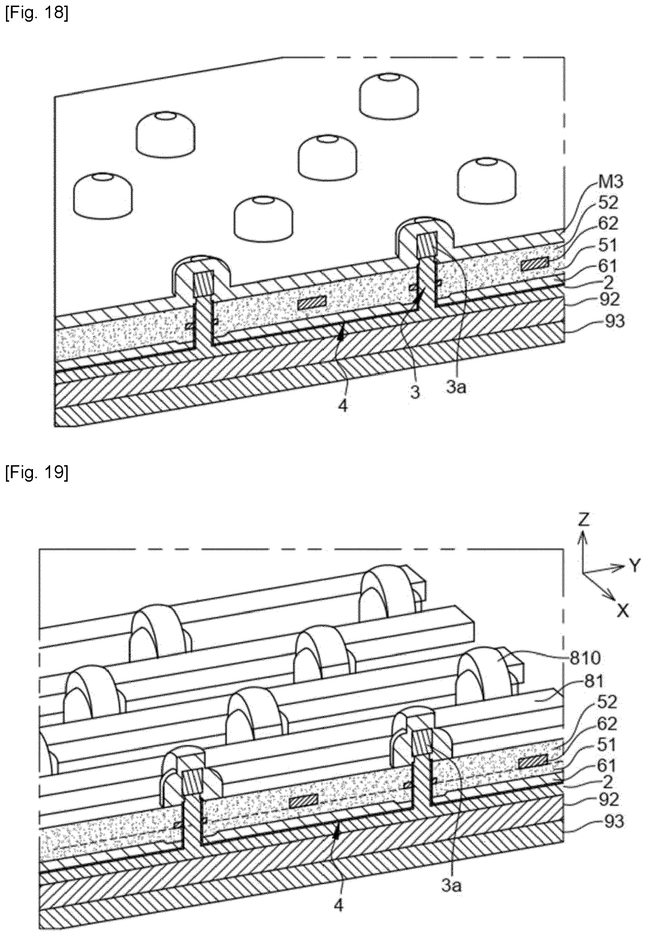

La formation S8 des lignes de lecture 81 peut comprendre, dans un deuxième temps, le dépôt d'une troisième couche conductrice M3, en contact avec la surface de contact 330 de chaque pilier 3 et sur la deuxième couche de séparation 52, tel qu'illustré par la figure 18. La troisième couche conductrice M3 présente une épaisseur pouvant être comprise entre 10 nm et 15 nm. La troisième couche conductrice M3 peut être réalisée à partir de silicium polycristallin dopé. Son dépôt peut être précédé d'une épitaxie de silicium dopé au phosphore Si :P ou de silicium et germanium dopé au bore SiGe :B. De cette manière, l'interface entre la surface de contact 330 de chaque pilier 3 et la troisième couche conductrice M3 est améliorée.

La formation S8 des lignes de lecture 81 peut également comprendre la structuration de la troisième couche conductrice M3 de manière à obtenir chaque ligne de lecture 81 telles qu'illustrées par la figure 19. La structuration de troisième couche conductrice M3 peut être réalisée par photolithographie d'un masque de résine à travers lequel troisième couche conductrice M3 est gravée. La structuration est préférentiellement réalisée de manière à former des lignes de lecture 81 sensiblement parallèles les unes aux autres. Par sensiblement parallèle, on entend parallèle à ± 30° près, préférentiellement à ± 20°, voire à ± 10° près. Elle est également réalisée de manière à disposer deux lignes de lecture 81 de part et d'autre d'un pilier 3, chacune des lignes étant au moins en contact avec la surface de contact 330 dudit pilier 3. Les lignes de lecture 81 illustrées par la figure 19 comprennent également une pluralité de portions transversales 810 recouvrant entièrement les plots de protection 3a et les surface de contact 330 des piliers 3. Les portions transversales 810 apparaissent lorsque le masque en résine photolithographié comporte des portions au-dessus de chaque pilier 3, protégeant ces dernier pendant la gravure et évitant de retirer la troisième couche conductrice M3 des flancs des plots de protection 3a et des surfaces de contact 330.

La structuration de la troisième couche conductrice M3 peut également être réalisée de manière auto-alignée, sans nécessiter de portions transversales 810. La gravure de la troisième couche conductrice M3 est par exemple réalisée de manière anisotrope à travers un masque en résine photolithographié ne comprenant pas de portions au-dessus de chaque pilier 3. La topologie de chaque pilier 3 a pour effet de former des flancs de troisième couche conductrice M3 autour de chaque pilier 3.

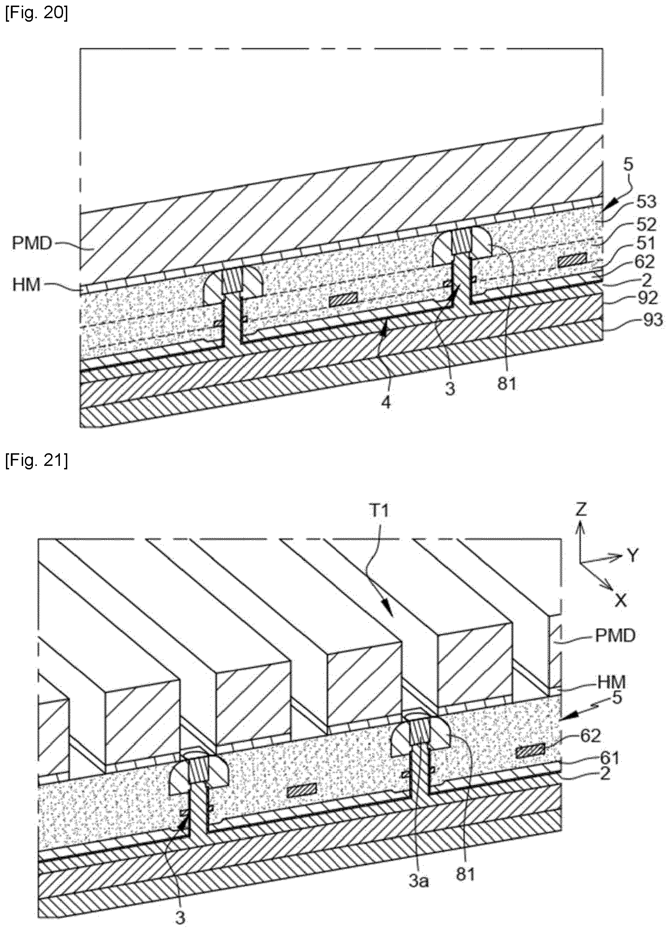

Les figures 20 à 28 illustrent la formation S9 des grilles de chargement 82 et la formation S10 des vias de contrôle 72. Ces formations S9, S10 sont préférentiellement réalisées de manière simultanée.

Elles comprennent, dans un premier temps, le dépôt d'une troisième couche de séparation 53 et l'aplanissement de la troisième couche de séparation 53, tel qu'illustré par la figure 20. Le dépôt de la troisième couche de séparation 53 est réalisée de manière à recouvrir toute la structure, notamment les lignes de lecture 81 et préférentiellement la deuxième couche de séparation 52 et les plots de protection 3a lorsque ceux-ci ne sont pas recouverts par des lignes de lecture 81. La troisième couche de séparation 53 peut être réalisée à partir d'oxyde de silicium. La troisième couche de séparation 53 est ensuite aplanie jusqu'à libérer le sommet des plots de protection 3a. Lors de cette étape, une partie de chaque ligne de lecture 81 peut être retirée, notamment lorsque ces dernières recouvrent les plots de protection 3a. En procédant de la sorte, chaque plot de protection 3a débouche de la surface de la troisième couche de séparation 53.

La troisième couche de séparation 53, forme, avec les deuxième et première couches de séparation 52, 51, une couche isolante 5.

La formation des grilles de chargement 82 et des vias 72 comprend également le dépôt d'un masque dur HM, par exemple en SiN, et d'un matériau d'encapsulation PMD, par exemple en SiO₂.

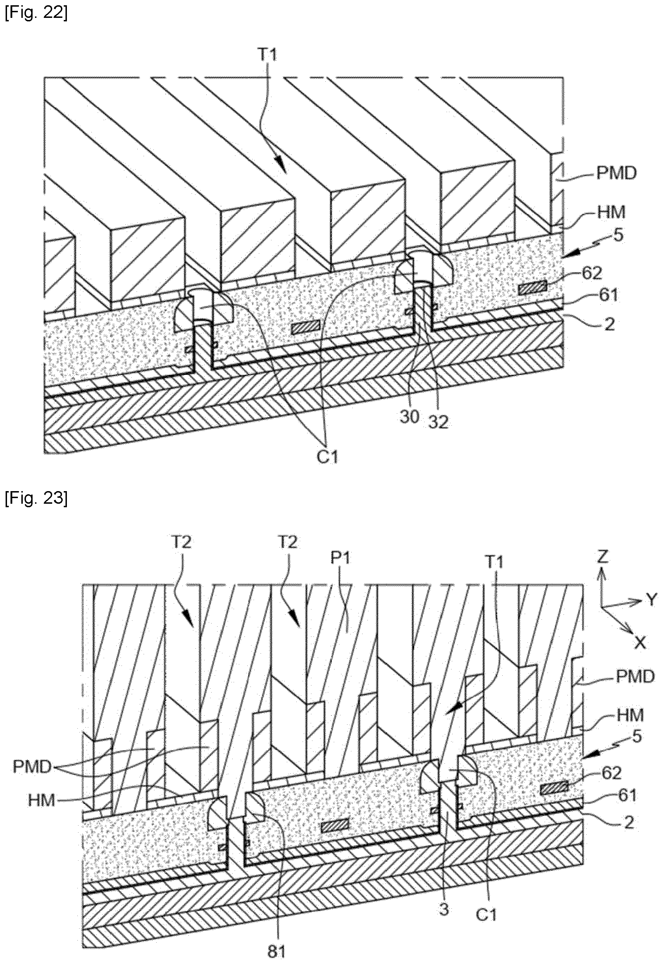

Les figures 21 et 22 illustrent la gravure sélective des plots de protection 3a par rapport à la troisième couche de séparation 53 et par rapport aux lignes de lecture 81. Elle comprend dans un premier temps, la formation de premières tranchées T1 dans le masque dur HM et le matériau d'encapsulation PMD. Ces premières tranchées T1 sont formées, par exemple par gravure, de manière à atteindre le sommet des plots de protection 3a. Les premières tranchées T1 sont orientées perpendiculairement aux lignes de couplage 62, c'est-à-dire selon la direction X sur la figure 21. Elles sont également agencées à l'aplomb d'une ligne de piliers 3 alignée selon la direction X.

La gravure des plots de protection 3a est réalisée grâce au dégagement procuré par les premières tranchées T1. Elle peut être réalisée de manière isotrope. Elle est préférentiellement arrêtée sur le sommet 32 de chaque pilier 3, laissant apparaître le matériau semiconducteur de chaque pilier 3. La gravure des plots de protection 3a permet ainsi de former une pluralité de premières cavités C1, ou de puits, à l'aplomb de chaque pilier 3. Chaque première cavité C1 comprend des bords qui sont préférentiellement formé par une ligne de lecture 81. Chaque première cavité C1 au niveau de la tête 32 des piliers 3 est destinée à accueillir une grille de chargement 82 permettant de former, avec un pilier 3 et une ligne de lecture 81, un transistor à électron unique.

Les figures 23 à 26 illustrent des étapes intermédiaires permettant de préparer la formation des vias 72. Ces étapes visent à former des deuxièmes cavités C2 dans lesquelles seront déposées les vias 72.

Dans un premier temps, les premières tranchées T1 et les premières cavités C1, précédemment vidées, sont remplies d'une première résine de protection P1 de manière à recouvrir totalement le matériau d'encapsulation PMD, tel qu'illustré par la figure 23. Des deuxièmes tranchées T2 sont réalisées dans la résine de protection et dans le matériau d'encapsulation PMD de manière à exposer une partie de la couche de masque dur HM. Ces deuxièmes tranchées T2 sont par exemple réalisées par gravure anisotrope, ladite gravure étant arrêtée au niveau du masque dur HM. Les deuxièmes tranchées T2 sont également orientées perpendiculairement aux lignes de couplage 61, c'est-à-dire selon la direction X. Elles sont agencées de sorte qu'elles soient équidistantes de deux colonnes de couplage 62 consécutives. Ainsi, elles croisent les lignes de couplage 61 mais les colonnes de couplage 62.

Dans un second temps, la première résine de protection P1 est retirée de manière sélective par rapport au matériau d'encapsulation PMD, au masque dur HM et aux lignes de lecture 81. Les premières et deuxièmes tranchées T1, T2 sont libres et les premières cavités C1 à l'aplomb des piliers 3 également.

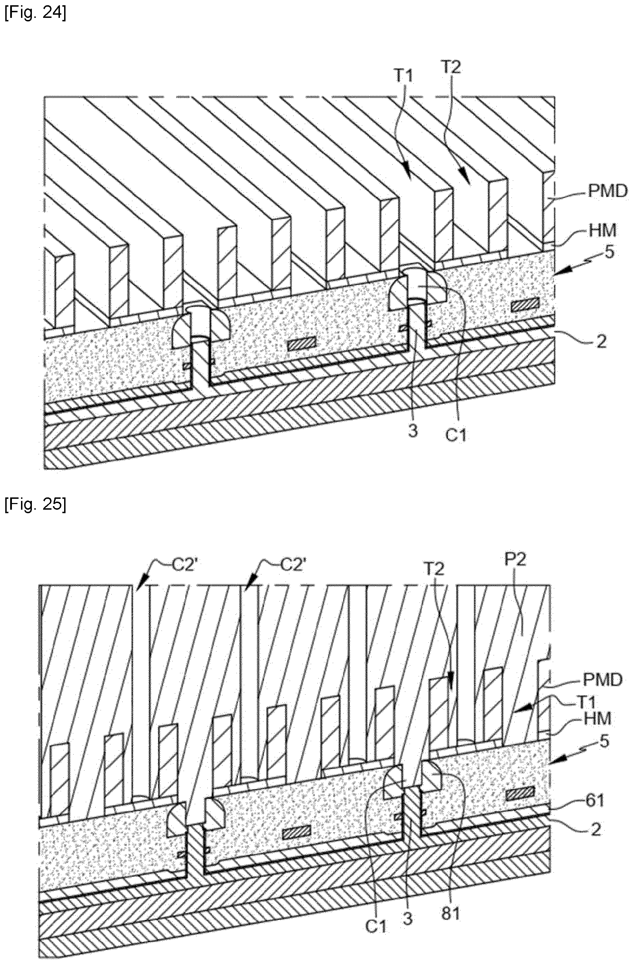

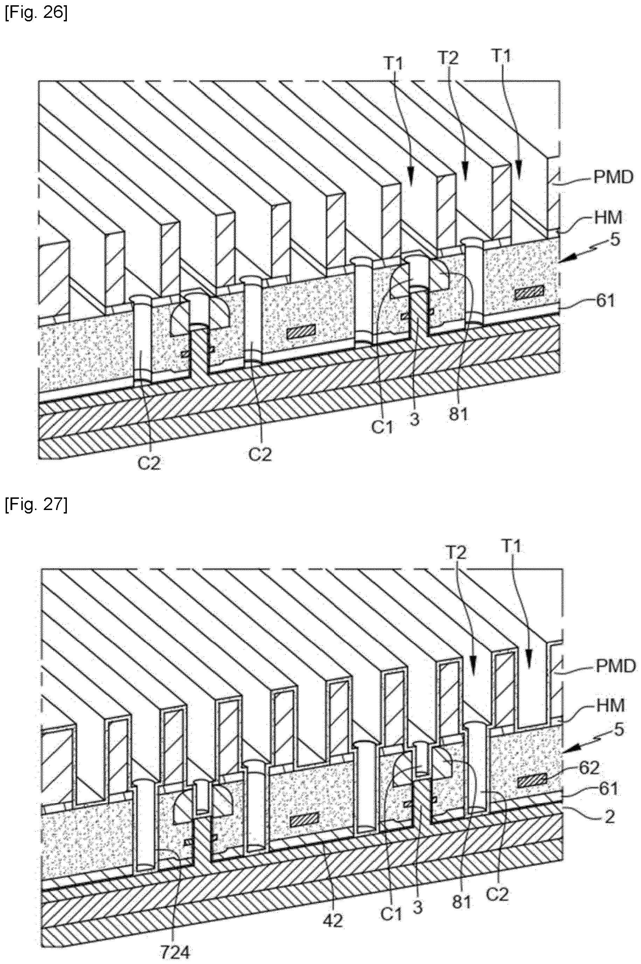

Les figures 25 et 26 montrent la gravure, en deux temps, de deuxièmes cavités C2. Dans un premier temps, une deuxième résine de protection P2 est déposée de manière à recouvrir totalement le matériau d'encapsulation PMD, tel qu'illustré par la figure 25. Les premières cavités C1, les premières et deuxièmes tranchées T1, T2 sont remplies par la deuxième résine de protection P2.

Ensuite, des cavités intermédiaires C2' sont formées, par exemple par gravure, dans la deuxième résine de protection P2. Ces cavités intermédiaires C2' sont gravées jusqu'à atteindre le masque dur HM. Chaque cavité intermédiaire C2' est disposée à l'aplomb d'une ligne de couplage 61.

Les deuxièmes cavités C2 sont formées par une gravure complémentaire, à partir du fond des cavités intermédiaires C2', c'est-à-dire à partir du masque dur HM, jusqu'à atteindre la face avant 2a de la couche qubits 2. Les deuxièmes cavités C2 sont gravée à travers la couche isolante 5, travers une ligne de couplage 61 et à travers l'espaceur 42. Le diamètre des deuxièmes cavités C2 est choisi de manière à ne pas couper les lignes de couplage 61. La largeur des lignes de couplage 61 peut également être dimensionnée pour prévoir la gravure des deuxièmes cavités C2. Elles présentent par exemple un élargissement à l'endroit où doit se former une deuxième cavité C2.

La deuxième résine de protection P2 est ensuite retirée, laissant libre les premières et deuxièmes tranchées T1, T2, et les premières et deuxièmes cavités C1, C2, tel qu'illustré par la figure 26.

Les vias de contrôle 72 forment une grille au niveau de la couche qubits 2, de manière à pouvoir moduler le champ électrique dans la couche qubits 2 sans réaliser de contact électrique. La figure 27 montre une étape, commune à la formation S9, S10 des grilles de chargement 82 et des vias de contrôle 72 dans les, respectivement premières et deuxièmes cavités C1, C2. Elle comprend par exemple un dépôt d'un oxyde ou d'un diélectrique sur les parois formants les premières ou deuxièmes cavités C1, C2 de manière à former une couche d'oxyde 724 dite « oxyde de grille ». Alternativement, elle comprend une oxydation des parois formant les premières et deuxièmes cavités C1, C2, de manière à former l'oxyde de grille 724. L'oxyde de grille 724 est préférentiellement formé par oxydation thermique et présente avantageusement une épaisseur comprise entre 2 nm et 5 nm.

L'oxyde de grille 724 permet également d'isoler électriquement les vias 72 et les grilles de chargement des, respectivement, lignes de couplage 61 et lignes de lecture 81.

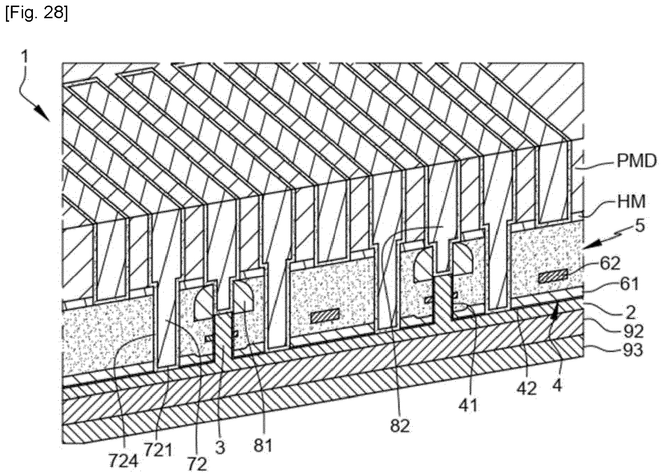

Les premières et deuxièmes cavités C1, C2 sont ensuite remplies avec un matériau conducteur tel qu'illustré par les figures 28 de manière à former les grilles de chargement 82 et les vias 72. Le matériau conducteur est par exemple un métal ou un ensemble de couches métalliques. Le remplissage de chaque cavité C1, C2 comprend par exemple un dépôt conforme d'une première couche métallique, par exemple de titane Ti, de manière à recouvrir l'oxyde de grille au fond de chaque cavité C1, C2. Le remplissage des cavités C1, C2 peut également comprendre le dépôt conforme de nitrure de titane TiN, de manière à recouvrir la première couche métallique. Enfin, le remplissage peut comprendre le dépôt d'une deuxième couche métallique, par exemple en tungstène W, recouvrant la couche de siliciure et remplissant totalement chaque cavité C1, C2.

Le matériau conducteur est préférentiellement aplani jusqu'à atteindre le matériau d'encapsulation PMD. Ainsi, les grilles de chargement 82 et les vias 71 sont électriquement déconnectées.

Les vias de contrôle 72 présentent ainsi une base 721 dont la distance par rapport à la face avant 2a de la couche qubits 2 est contrôlée par l'oxyde de grille 724.

Les grilles de chargement 82 ainsi formées peuvent être structurées de manière à connecter une pluralité de transistors à électron unique. Elles sont avantageusement sensiblement parallèles les unes aux autres et orientées selon l'une des directions X, Y. De la sorte, les grilles de chargement 82 peuvent contrôler une pluralité de piliers 3. Toutefois, afin de réduire le couplage capacitif entre les lignes de lecture 81 et les grilles de chargement 82, ces dernières sont avantageusement orientées perpendiculairement aux lignes de lecture 81.

## Revendications

1. Circuit (1) électronique quantique comprenant :
- une couche semiconductrice (2) destinée à recevoir des qubits, dite « couche qubits », présentant une première face (2a) dite « face avant » ;
- des piliers semiconducteurs (3), distants les uns des autres, s'étendant perpendiculairement à la face avant (2a) de la couche qubits (2) depuis la couche qubits (2), chaque pilier semiconducteur (3) comprenant une première extrémité (31), dite « base », en contact avec la face avant (2a) de la couche qubits (2) ;
- des couches diélectriques (41) dites « diélectriques de flanc », chaque diélectrique de flanc (41) entourant le flanc (33) d'un des piliers semiconducteurs (3) ;
- une couche diélectrique (42) dite « espaceur » s'étendant au contact de la face avant (2a) de la couche qubits (2) et entourant la base (31) de chaque pilier semiconducteur (3) ;
- des premières et deuxièmes électrodes conductrices (61, 62), dites respectivement « lignes de couplage » et « colonnes de couplage », pour moduler le potentiel électrostatique dans les piliers semiconducteurs :
- les lignes de couplage (61) étant parallèles les unes aux autres et s'étendant parallèlement à la face avant (2a) de la couche qubits (2), chaque ligne de couplage (61) étant en contact avec le diélectrique de flanc (41) d'au moins un des piliers semiconducteurs (3) ;
- les colonnes de couplage (62) étant parallèles les unes aux autres et perpendiculaires aux lignes de couplage (61), s'étendant parallèlement à la face avant (2a) de la couche qubits (2) et distantes des lignes de couplage (61), chaque colonne de couplage (62) étant en contact avec le diélectrique de flanc (41) d'au moins un des piliers semiconducteurs (3) ;
le circuit étant **caractérisé en ce qu'**il comprend également des troisièmes électrodes conductrices, dites « lignes de contrôle », et des vias conducteurs, dits « vias de contrôle », pour moduler le potentiel électrostatique au niveau de la couche qubits et former des boîtes quantiques dans la couche qubits :
- les lignes de contrôle (71) étant parallèles les unes aux autres et parallèles aux lignes de couplages (61) et s'étendant sur l'espaceur (42), chaque ligne de contrôle (71) étant distante des lignes de couplage (61), des colonnes de couplage (62) et des diélectriques de flanc (41) des piliers semiconducteurs (3) ; et
- les vias de contrôle étant distants des colonnes de couplage (62), des lignes de contrôle (71) et des diélectriques de flanc (41) des piliers semiconducteurs (3), chacun des vias de contrôle (72) s'étendant perpendiculairement à la face avant (2a) de la couche qubits (2), chaque via (72) présentant une première extrémité (721) disposée à proximité de la face avant (2a) de la couche qubits (2), sans contact électrique avec la couche qubits (2).

2. Circuit (1) selon la revendication précédente, dans lequel la première extrémité (721) de chaque via (72) est disposée à moins de 15 nm de la face avant (2a) de la couche qubits (2).

3. Circuit (1) selon l'une des revendications précédentes, dans lequel l'épaisseur de l'espaceur (42) est inférieure à 15 nm.

4. Circuit (1) selon l'une des revendications précédentes, dans lequel chaque ligne de contrôle (71) est disposée entre deux lignes de couplage (61) consécutives et chaque via de contrôle (72) est disposé entre deux colonnes de couplage (62) consécutives.

5. Circuit (1) selon l'une des revendications précédentes, dans lequel chacun des vias de contrôle (72) traverse, sans contact électrique, une des lignes couplages (61).

6. Circuit (1) selon l'une des revendications précédentes, dans lequel chaque ligne de couplage (61) s'étend sur l'espaceur (42).

7. Circuit (1) selon l'une des revendications précédentes, dans lequel les lignes de couplage (61) et les lignes de contrôle (71) s'étendent dans un premier plan, parallèle à la première face (2a) de la couche qubit (2), dans lequel les colonnes de couplage (62) s'étendent dans un deuxième plan également parallèle à la première face (2a) de la couche qubit (2), le premier plan étant disposé entre la première face (2a) de la couche qubit (2) et le deuxième plan.

8. Circuit (1) selon l'une des revendications précédentes, dans lequel chaque via (72) présente une deuxième extrémité (722), opposée à la première extrémité (721), les deuxièmes extrémités (722) d'une pluralité de vias (72) étant électriquement connectées entre elles.

9. Circuit (1) selon l'une des revendications précédentes, dans lequel chaque pilier semiconducteur (3) comprend une deuxième extrémité (32), dite « tête », opposée à la base (31), la tête (32) du pilier semiconducteur (3) comprend une surface de contact (330) n'étant pas entourée par le diélectrique de flanc (41).

10. Circuit (1) selon la revendication précédente, dans lequel le circuit (1) comprend également des quatrièmes électrodes (81) dites « lignes de lecture », chaque ligne de lecture (81) étant en contact avec la surface de contact (330) d'au moins un des piliers semiconducteurs (3).

11. Circuit (1) selon l'une des deux revendications précédentes, dans lequel le circuit (1) comprend également des structures de grilles (82) dites « grilles de chargement », chaque grille de chargement (82) étant en contact avec la tête (32) d'au moins un des piliers semiconducteurs (3).

12. Procédé de fabrication d'un circuit électronique quantique, le procédé étant mis en oeuvre à partir d'un substrat (9) comportant une première couche semiconductrice (91) monocristalline et comprenant les étapes suivantes :
- former (S1), à partir de la première couche semiconductrice (91), des piliers semiconducteurs (3) distants les uns des autres, chaque pilier semiconducteur (3) présentant une première extrémité (31), dite « base » ; et une couche semiconductrice (2) destinée à recevoir des qubits dite « couche qubits », à la base (31) de chaque pilier semiconducteur (2), la couche qubits (2) présentant une première face (2a) dite « face avant » ;
- oxyder (S2) le flanc de chaque pilier semiconducteur (3) et la face avant (2a) de la couche qubits (2) de manière à former une première couche diélectrique (4) comprenant des premières portions (41), dites « diélectriques de flanc », chaque diélectrique de flanc (41) entourant le flanc d'un des piliers semiconducteurs (3), et une deuxième portion (42) dite « espaceur », s'étendant au contact de la face avant (2a) de la couche qubits (2) et entourant la base (31) de chaque pilier semiconducteur (3) ;
- former (S3) des premières électrodes conductrices (61) dites « lignes de couplage », pour moduler le potentiel électrostatique dans les piliers semiconducteurs (3), les lignes de couplage étant parallèles les unes aux autres et s'étendant parallèlement à la face avant (2a) de la couche qubits (2), chaque lignes de couplage (61) étant en contact avec le diélectrique de flanc (41) d'au moins un des piliers semiconducteurs (3) ;
- former (S4) des troisièmes électrodes conductrices (71), dites « lignes de contrôle », pour moduler le potentiel électrostatique dans la couche qubits (2), les lignes de contrôle étant parallèles les unes aux autres et parallèles aux lignes de couplages (61) et s'étendant sur l'espaceur (42), chaque ligne de contrôle (71) étant distante des lignes de couplage (61) et des diélectriques de flanc (41) des piliers semiconducteurs (3) ;
- former (S6) des deuxièmes électrodes conductrices (62) dites « colonnes de couplage », pour moduler le potentiel électrostatique dans les piliers semiconducteurs (3), les colonnes de couplage étant parallèles les unes aux autres et perpendiculaires aux lignes de couplage (61), s'étendant parallèlement à la face avant (2a) de la couche qubits (2) et distantes des lignes de couplage (61) et des lignes de contrôle (71), chaque colonne de couplage (62) étant en contact avec le diélectrique de flanc (41) d'au moins un des piliers semiconducteurs (3) ;
- former (S10) des vias conducteurs (72), dits « vias de contrôle », pour moduler le potentiel électrostatique dans la couche qubits (2) et former, avec les lignes de contrôle, des boîtes quantiques dans la couche qubits (2), les vias de contrôle étant distants des colonnes de couplage (62), des lignes de contrôle (71) et des diélectriques de flanc (41) des piliers semiconducteurs (3), chacun des vias de contrôle (72) s'étendant perpendiculairement à la face avant (2a) de la couche qubits (2) depuis l'espaceur (42) et traversant, sans contact électrique, une des lignes couplages (61).

13. Procédé de fabrication selon la revendication précédente, dans lequel les lignes de couplage (61) et les lignes de contrôle (71) sont formées (S3, S4) simultanément.
